# EUROPÄISCHE PATENTSCHRIFT

(11) **EP 2 750 256 B1**
(45) Veröffentlichungstag und Bekanntmachung des Hinweises auf die Patenterteilung: **23.12.2015**
(21) Anmeldenummer: 14001126.3
(22) Anmeldetag: 03.05.2011
(51) Int. Cl.: H02H 1/00

(54) **VERFAHREN ZUR ERKENNUNG VON STÖRLICHTBÖGEN UND SCHUTZSCHALTER**
METHOD FOR IDENTIFYING ARCING FAULTS AND CORRESPONDING CIRCUIT BREAKER
PROCÉDÉ DE DÉTECTION DES DÉFAUTS D'ARC ET DISJONCTEUR DE PROTECTION

(30) Priorität: 23.02.2011 DE 102011012004
(43) Veröffentlichungstag der Anmeldung: 02.07.2014
(62) Teilanmeldung aus: 11720033.7
(73) Patentinhaber: Ellenberger & Poensgen GmbH, D-90518 Altdorf (DE)
(72) Erfinder: Miklis, Markus, 90592 Pfeifferhütte (DE)
(74) Vertreter: FDST Patentanwälte

(56) Entgegenhaltungen:
- WO-A1-94/22031
- WO-A1-2008/049436
- GB-A- 2 348 751

## Beschreibung

Die Erfindung betrifft Verfahren zur Erkennung von Störlichtbögen innerhalb eines eine Netzfrequenz, einen elektrischen Strom und eine elektrische Spannung aufweisenden Stromkreises sowie einen danach arbeitenden Schutzschalter.

Innerhalb eines elektrischen Stromkreises können sogenannten Störlichtbögen auftreten. Störlichtbögen sind unerwünschte Ströme zwischen zumindest einem Element des Stromkreises und einem weiteren Element, wobei zwischen den beiden Elementen eine Potentialdifferenz existiert. Üblicherweise stehen die beiden Elemente nicht in direktem elektrischem Kontakt, sondern meist befindet sich zwischen diesen eine Isolierung. Ist die Isolierung defekt, indem diese beispielsweise aufgrund von Alterung porös geworden ist oder infolge mechanischen Einwirkens zumindest teilweise entfernt ist, so ist es möglich, dass zwischen den beiden Elementen ein weiterer Stoff eindringt und sich dort anlagert. Dieser Stoff kann flüssig, beispielsweise Wasser, oder gasförmig, insbesondere Luft, sein. Aufgrund der fehlenden Isolationswirkung ist es bei den innerhalb des Stromkreises auftretenden Strömen und/oder Spannungen möglich, dass ein elektrischer Überschlag, der Störlichtbogen, zwischen den beiden Elementen auftritt.

Es werden drei verschiedene Typen von Störlichtbögen, auch Arc genannt, unterschieden. Bei dem sogenannten Wet-Arc ist der eindringende Stoff eine Flüssigkeit, meist Wasser, die eine hohe elektrische Leitfähigkeit aufweist. Das weitere Element ist meist elektrisch mit Masse verbunden oder geerdet und nicht zwangsläufig ein Bestandteil des Stromkreises. Aufgrund der hohen elektrischen Leitfähigkeit und somit aufgrund des geringen elektrischen Widerstandes der Flüssigkeit können zwischen den beiden Elementen vergleichsweise hohe Ströme auftreten, was zu einer Beeinträchtigung etwaiger Verbraucher des elektrischen Stromkreises führen kann.

Bei einem sogenannten Parallel-Arc ist der eindringende Stoff ein Gas, insbesondere Luft. Das weitere Element ist meist elektrisch mit Masse verbunden oder geerdet und nicht zwangsläufig ein Bestandteil des Stromkreises. Aufgrund des elektrischen Feldes zwischen den beiden Elementen wird das Gas ionisiert und es kann ein elektrischer Strom zwischen den beiden Elementen fließen. Schon bei Potentialdifferenzen von ca. 30 Volt ist ein derartiger Überschlag möglich. Aufgrund der vergleichsweise schlechten elektrischen Leitfähigkeit des ionisierten Gases ist der elektrische Strom zwischen den beiden Elementen nicht konstant, sondern vielmehr hochfrequent, was zu einer hohen thermischen Aufladung der beiden Elemente, des Stoffes und/oder deren jeweiliger Umgebung führt. Die hierbei auftretenden Temperaturen erreichen bis zu einige tausend Grad, so dass eine weitere Beschädigung der Isolation, der Elemente und/oder der jeweiligen Umgebung nicht ausgeschlossen ist.

Insbesondere bei Flugzeugen ist diese Gefahr besonders groß, da üblicherweise verlegte Kabel zu Kabelbäumen zusammen gefasst werden. Falls das erste Element eines dieser Kabel ist, kann ein auftretender Störbogen den gesamten Kabelbaum schädigen und somit die Betriebssicherheit des Flugzeuges gefährden. Weiterhin ist es möglich, dass den Kabelbaum umgebende Elemente oder der Kabelbaum selbst in Brand geraten.

Ein weiterer Störlichtbogen-Typ ist der Seriell-Arc. Bei diesem ist das weitere Element das erste Element selbst, welches meist ein Kabel ist. Der Überschlag erfolgt entlang des Kabels, wobei der eingedrungene Stoff meist Luft ist, die durch eine porös gewordenen Isolierung in elektrischem Kontakt zu dem Kabel steht. Der Mechanismus der zu diesem Störlichtbogen führt ist vergleichbar mit dem Parallel-Arc und ebenso auch dessen Auswirkungen.

Aus der WO 94/22031 A1 sind zwei Verfahren zum Erkennen von Störlichtbögen bekannt. Das erste der beiden Verfahren sieht vor, den elektrischen Strom oder die elektrische Spannung innerhalb eines Wechselstromkreises auf Störsignale zu überwachen, deren Länge im Wesentlichen einer halben Netzfrequenz entspricht.

Hierbei werden die zwischen zwei aufeinanderfolgenden Störsignalen gebildeten Zeiträume auf deren Länge, deren Beginn oder deren Ende hin analysiert. Sofern zwei im Abstand einer Netzfrequenz aufeinanderfolgende Zeiträume vorliegen, wird ein Zähler erhöht. Falls eine bestimmte Anzahl von regelmäßigen störsignalfreien Zeiträumen vorliegt ist ein Störlichtbogen erkannt. Anstatt dessen können nach Registrierung der bestimmten Anzahl von Störlichtbogen weiterhin die Zeiträume gezählt werden. Falls ein Zeitraum unregelmäßig ist, wird der Zähler um einen vorgegebenen Wert reduziert. Falls der Zähler eine bestimmte zweite Anzahl erreicht hat, wird ein Störlichtbogen gemeldet.

Bei dem zweiten Verfahren werden Störsignale auf deren Unregelmäßigkeiten hin überprüft. Falls sich aufeinanderfolgende Störsignale in deren Position relativ zur Netzfrequenz und deren Länge unterscheiden, ist ein Störlichtbögen erkannt. Zusätzlich wird der Anstieg des jeweiligen Störsignals analysiert, da der Erfinder erkannt hat, dass Störsignale, die von Störlichtbögen hervorgerufen werden, einen zeitlich steileren Anstieg aufweisen als etwaige Störsignale, die von Halbleiterschaltelementen innerhalb des Stromkreises bedingt sind.

Die vorgestellten Verfahren werden von einem Schutzschalter, einem Überwachungselement und einem tragbaren Analysegerät ausgeführt.

In der WO 2008/049436 A1 ist ein Schutzschalter zur Überwachung von losen Verbindungen in einem Stromkreis bekannt. Der Schutzschalter löst aus, wenn in dem zu überwachenden Stromkreis ein hochfrequentes Signal detektiert wird. In einer Weiterbildung wird der Stromkreis mittels des Schutzschalters unterbrochen, wenn eine bestimmte Anzahl von derartigen Signalen innerhalb eines vorgegebenen Zeitfensters ermittelt wurde.

Aus der GB 2 348 751 A ist ein Verfahren zur Überwachung von Störlichtbögen innerhalb eines in einem Flugzeug realisierten Stromkreises bekannt. Hierbei wird der Anstieg von Störsignalen registriert und anhand dessen ein Störlichtbögen erkannt. Dabei wird die Anzahl von derartigen Störsignalen gezählt, die innerhalb eines zur halben Netzfrequenz korrespondierenden Zeitfensters auftreten.

Der Erfindung liegt die Aufgabe zugrunde, sowohl ein besonders geeignetes Verfahren zur Erkennung von Störlichtbögen innerhalb eines eine Netzfrequenz, einen elektrischen Strom und eine elektrische Spannung aufweisenden Stromkreises als auch einen besonderes geeigneten Schutzschalter anzugeben.

Die das Verfahren betreffende Aufgabe wird erfindungsgemäß gelöst durch die Merkmale des Anspruchs 1. Vorteilhafte Weiterbildungen sind Gegenstand der hierauf rückbezogenen Unteransprüche.

Im Folgenden wird unter einem Störsignal eine Abweichung eines Istwertes eines elektrischen Stromes von einem zugehörigen Sollwert verstanden. Die Abweichung weist eine Zeitdauer und während dieser eine bestimmte Frequenz auf, wobei die Abweichung auch eine Anzahl von Frequenzen oder ein Frequenzband während dieser Zeitspanne aufweisen kann. Nachfolgend wird davon ausgegangen, dass ein Störsignal lediglich eine Frequenz umfasst, wobei jedoch das Störsignal auch mehrere Frequenzen umfassen kann.

Befinden sich die Frequenz der Abweichungen unterhalb einer NF1-Frequenz, wobei währenddessen der elektrische Strom oberhalb einer NF1-Grenzschwelle liegt, so wird dieses Störsignal als NF1-Signal bezeichnet. Unter einem NF2-Signal wird ein Störsignal verstanden, dessen Frequenz kleiner als eine NF2-Frequenz ist, während zeitgleich die Stromstärke größer als eine NF2-Grenzschwelle ist. Als Länge des NF1- Signals und als Länge des NF2-Signals wird die Zeitdauer bezeichnet, die das Störsignal mit den jeweiligen obigen Parametern andauert.

Als ein HF2-Signal wird eine Anzahl von Störsignalen, die eine Frequenz unterhalb einer HF2-Frequenz aufweisen, bezeichnet. Hierbei ist der zeitliche Abstand zweier aufeinanderfolgender Störsignale kleiner als eine HF2-Zeit, und die Anzahl der Störsignale ist größer als eine HF2-Anzahl. Tritt ein weiteres Störsignal mit einer Frequenz unterhalb der HF2-Frequenz innerhalb einer Zeitspanne, die kleiner als die HF2-Zeit ist, nach dem letzten Störsignal eines HF2-Signals auf, so wird das weitere Störsignal zu dem HF2-Signal gezählt und die Länge des HF2-Signals entsprechend verlängert. Dies führt unter anderem dazu, dass der zeitliche Abstand zweier aufeinanderfolgender HF2-Signale größer als die HF2-Zeit ist.

Folgen eine Anzahl von Zeiträumen, innerhalb derer mindestens jeweils ein HF2-Signal liegt, direkt aufeinander, so wird dies als eine Anhäufung bezeichnet. Die Länge jeder der Zeiträume beträgt hierbei einer Anhäufungs-Länge. Die Anzahl der Anhäufungen ist größer oder gleich einer Anhäufungs-Anzahl. Tritt in einem weiteren Zeitraum mit einer zeitlichen Länge, die der Anhäufungs-Länge entspricht, nach dem letzten ein HF2-Signal enthaltenden Zeitraum einer Anhäufung ein weiteres HF2-Signal auf, so wird der das weitere HF2-Signal enthaltende Zeitraum zu der Anhäufung gezählt und die Länge der Anhäufung entsprechend verlängert.

Es ist insbesondere möglich, dass ein Störsignal zu einer Anzahl der oben genannten Signale und/oder der Anhäufung beiträgt. Weiterhin wird im Folgenden davon ausgegangen, dass, falls ein Signal einen Zeitraum, eine Zeitspanne, eine zeitliche Phase oder eine zeitliche Periode startet, oder der Zeitraum, die Zeitspanne, die zeitliche Phase oder die zeitliche Periode mittels des Signals gestartet wird, das Signal zu dem Zeitraum, der Zeitspanne, der zeitlichen Phase oder der zeitlichen Periode gezählt wird, also innerhalb des Zeitraums, der Zeitspanne, der zeitlichen Phase oder der zeitlichen Periode liegt.

Das Verfahren nutzt einen nachfolgend als WET2-Anhäufungszähler bezeichneten Zähler und einen NF1-Zähler. Mit dem Start des Verfahrens werden der WET2-Anhäufungszähler und der NF1-Zähler jeweils auf null (0) gesetzt. Wenn der WET2-Anhäufungszähler null (0) beträgt und eine Anhäufung identifiziert wird, wird der WET2-Anhäufungszähler um eins (1) erhöht. Mit anderen Worten wird der Zählerstand des WET2-Anhäufungszählers um eins (1) erhöht, sobald eine Anhäufung innerhalb des elektrischen Stroms des Stromkreises erkannt wird. Mit jeder weiteren identifizierten Anhäufung wird der Zählerstand des WET2-Anhäufungszählers um eins (1) erhöht, solange der zeitliche Abstand zweier aufeinanderfolgender Anhäufungen kleiner der dritten Anhäufungs-Zeit ist. Wird nach einer der Anhäufungen für einen Zeitraum, der größer als eine dritte Anhäufungs-Zeit ist, keine Anhäufung gemessen, so wird entweder der WET2-Anhäufungszähler auf null (0) gesetzt, falls der Zählerstand des WET2-Anhäufungszähler kleiner oder gleich einem ersten WET2-Grenzwertes ist, oder es wird eine NF-Periode gestartet, falls der Zählerstand des WET2-Anhäufungszähler größer als der erste WET2-Grenzwert ist. Insbesondere wird der Zählerstand des WET2- Anhäufungszählers innerhalb der NF-Periode nicht weiter erhöht.

Jedes NF1-Signal, das innerhalb der NF-Periode gemessen wird, führt zu einer Erhöhung des NF1-Zählers um eins (1). Überschreitet der Zählerstand des NF1-Zählers einen WET2-Grenzwert, so wird ein Störlichtbogen gemeldet. Ist nach Ablauf der NF-Periode der Zählerstand kleiner als der WET2-Grenzwert, werden der WET2-Anhäufungszähler und der NF1-Zähler jeweils auf null (0) gesetzt.

Vorzugsweise sieht das Verfahren vor, einen Seriellzeitraum zu nutzen. Falls außerhalb des Seriellzeitraums in dem elektrischen Strom ein HF2-Signal registriert wird, so wird der Seriellzeitraum gestartet. In dem Seriellzeitraum werden die gegebenenfalls in dem elektrischen Strom vorhandenen NF1-Signale gezählt. Hlerbel werden lediglich diejenigen NF1-Signale gezählt, deren zeltlicher Abstand zueinander zwischen einer fünften Abbruch-Zeitspanne und einer sechsten Abbruch-Zeitspanne liegt, wobei die fünfte Abbruch-Zeitspanne kleiner als die sechste Abbruch-Zeitspanne ist. In einer ersten Messphase des Seriellzeitraums, die mit dem Start des Seriellzeitraums beginnt, werden die gegebenenfalls in dem elektrischen Strom vorhandenen HF2-Signale gezählt. Hierbei werden lediglich diejenigen HF2-Signale gezählt, deren zeitlicher Abstand zu dem jeweiligen vorhergehenden HF2-Siganl zwischen einer vierten Abbruch-Zeitspanne und einer dritten Abbruch-Zeitspanne liegt, wobei die vierte Abbruch-Zeitspanne kleiner als die dritte Abbruch-Zeitspanne Ist. Sollte einer der Abstände größer als die dritte Abbruch-Zeitspanne sein, so wird sowohl die erste Messphase abgebrochen als auch der Seriellzeitraum beendet.

Ist die Anzahl der innerhalb der ersten Messphase gezählten HF2-Signale gleich einer ersten Seriellen-Anzahl, wobei das den Seriellzeitraum startende NF2-Signal zu der Anzahl der gezählten HF2-Signale hinzu gezählt wird, so wird eine Halteperiode gestartet. Insbesondere wird die erste Messphase beendet, falls die Anzahl der gemessenen HF2-Signale gleich der ersten Seriellen-Anzahl ist, und geeigneterweise darauf im Anschluss die Halteperiode gestartet. Hierbei umfasst insbesondere die erste Messphase dasjenige zeitlich letzte HF2-Signal, mittels dessen die Anzahl der gemessenen HF2-Signale der ersten Seriellen-Anzahl entspricht, da das zeitlich letzte HF2-Slgnal die erste Messphase beendet und nicht die Halteperiode startet.

Nach Ablauf der Halteperiode werden in einer sich vorzugsweise direkt anschließenden zweiten Messphase die gegebenenfalls in dem elektrischen Strom vorhandenen HF2-Signale gezählt, deren zeitlicher Abstand zu dem vorhergehenden HF2-Signal zwischen der vierten Abbruch-Zeitspanne und der dritten Abbruch-Zeitspanne liegt. Sollte einer der Abstände größer als die dritte Abbruch-Zeitspanne sein, so wird sowohl die zweite Messphase abgebrochen als auch der Seriellzeitraum beendet. Insbesondere wird das zeitlich erste HF2-Signal der zweiten Messphase gezählt, wenn das zeitlich nachfolgende HF2-Signal zu dem ersten einen zeitlichen Abstand aufweist, der zwischen der vierten Abbruch-Zeitspanne und der dritten Abbruch-Zeitspanne liegt.

Ist die Anzahl der innerhalb der zweiten Messphase gezählten HF2-Signale gleich einer zweiten Seriellen-Anzahl, wird die Anzahl der NF1-Signale überprüft. Insbesondere wird die zweite Messphase beendet, falls die Anzahl der gemessenen HF2-Signale gleich der zweiten Seriellen-Anzahl ist, und geeigneterweise wird der Seriellzeitraum ebenfalls beendet. Falls die Anzahl der innerhalb des Seriellzeitraums gezählten NF1-Signale größer als eine dritten Seriellen-Anzahl ist, oder falls die Anzahl der innerhalb des Seriellzeitraums gezählten NF1-Signale gleich der dritten Seriellen-Anzahl ist, und für zumindest die fünfte Abbruch-Zeitspanne nach dem letzten gezählten NF1-Signal kein weiteres NF1-Signal in dem elektrischen Strom registriert wurde, wird ein Störlichtbogen gemeldet.

In einer zweckmäßigen Ausführungsform der Erfindung wird die elektrische Spannung überwacht. Ist für einen Zeitraum, der länger als eine zweite SPG-Zeitspanne ist, die elektrische Spannung kleiner als eine SPG-Spannung, so werden der WET2-Anhäufungszähler und der NF1-Zähler auf null (0) gesetzt. Die SPG-Spannung ist hierbei vorteilhafterweise konstant, kann jedoch ebenso ein variabler Schwellwert unter- oder oberhalb einer Sollspannung sein. Die beiden Zähler werden ebenfalls zurückgesetzt, falls sich die Längen zweier aufeinanderfolgender Hochzeitspannen um mehr als eine dritte SPG-Zeitspanne unterscheiden. Als Hochzeitspannen wird die Zeitspanne bezeichnet, innerhalb derer die Spannung größer als die SPG-Spannung ist. Gegebenenfalls wird in beiden Fällen die NF-Periode abgebrochen, falls diese bereits begonnen hat. Sollten die beiden Zähler aufgrund der elektrischen Spannung auf null (0) gesetzt werden, so werden anschließend der WET2-Anhäufungszähler und der NF1-Zähler für eine erste SPG-Zeitspanne nicht verändert.

Alternativ oder in Kombination hierzu wird der Seriellzeitraum beendet, falls dieser bereits begonnen hat, und für die ersten SPG-Zeitspanne nicht gestartet, falls für einen Zeitraum, der länger als die zweite SPG-Zeitspanne ist, die elektrische Spannung kleiner als die SPG-Spannung ist. Mit andern Worten führt ein innerhalb der SPG-Zeitspanne gemessenes HF2-Signal nicht zu einem Starten des Seriellzeitraums. Falls sich die Längen zweier aufeinanderfolgender Hochzeitspannen um mehr als die dritte SPG-Zeitspanne unterscheiden, so wird der Seriellzeitraum beendet, falls dieser bereits begonnen hat, und für die ersten SPG-Zeitspanne nicht gestartet.

Zweckmäßigerweise wird der WET2-Anhäufungszähler und der NF1-Zähler auf null (0) zurückgesetzt und während eines sich daran anschließenden Parallelzeitraums nicht verändert, falls ein NF2-Signal gemessen wird, dessen Länge größer als die NF2-Grenzlänge ist. In Kombination dazu wird die NF-Periode abgebrochen, falls diese bereits begonnen hat. Beziehungsweise wird der Seriellzeitraum beendet, falls dieser bereits begonnen hat, und auf jeden Fall für den Parallelzeitraum nicht gestartet, falls ein NF2-Signal gemessen wird, das länger als die NF2-Grenzlänge andauert.

Ein Störlichtbogen wird gemeldet, falls innerhalb des Parallelzeitraums zwischen allen aufeinanderfolgenden HF2-Signalen der zeitliche Abstand größer oder gleich der ersten Störlichtbogen-Zeitspanne ist, wobei einer der Abstände größer oder gleich der zweiten Störlichtbogen-Zeitspanne ist. Hierbei ist die Anzahl der HF2-Signale, die zu der Meldung führt, abhängig von etwaigen NF2-Signalen, die innerhalb der dritten Störlichtbogen-Zeitspanne des Parallelzeitraums in dem elektrischen Strom gemessen werden. Ist die Anzahl der gemessenen NF2-Signale größer oder gleich der zweiten Störlichtbogen-Anzahl und kleiner oder gleich der dritten Störlichtbogen-Anzahl, so wird der Störlichtbogen gemeldet, falls eine Anzahl von HF2-Signalen innerhalb des Parallelzeitraums gemessen wurde, die mindestens der ersten Störlichtbogen-Anzahl entspricht. Ist die Anzahl der gemessenen NF2-Signale größer als die dritten Störlichtbogen-Anzahl, so wird erst nachdem eine Anzahl, die größer oder gleich der vierten Störlichtbogen-Anzahl ist, von HF2-Signalen der Störlichtbogen gemeldet.

Der Parallelzeitraum wird beendet und kein Störlichtbogen gemeldet, falls während des Parallelzeitraums die Länge eines NF2-Signals kürzer als die NF2-Grenzlänge ist, oder für einen Zeitraum, dessen Länge zumindest der Länge der zweiten Abbruch-Zeitspanne entspricht, kein NF2-Signal gemessen wurde. Sollte innerhalb des Parallelzeitraums für die erste Abbruch-Zeitspanne die elektrische Spannung kleiner als die Abbruch-Spannung sein, so wird der Parallelzeitraum beendet und auch kein Störlichtbogen gemeldet.

Folglich wird ein Störlichtbogen gemeldet, falls innerhalb des zeitlich ersten Abschnitts des Parallelzeitraums, der die Länge der dritten Störlichtbogen-Zeitspanne aufweist, eine Anzahl von NF2-Signalen, wobei das den Parallelzeitraum startenden NF2-Signal ebenfalls dazu gezählt wird, die zwischen einschließlich der zweiten Störlichtbogen-Anzahl und der dritten Störlichtbogen-Anzahl liegt, und eine Anzahl von HF2-Signalen gezählt werden, die größer oder gleich der ersten Störlichtbogen-Anzahl ist. Werden in dem ersten Abschnitt mehr NF2-Signale gemessen, wobei hier ebenso das den Parallelzeitraum startenden NF2-Signal dazu gezählt wird, so wird erst nachdem in dem Parallelzeitraums mindestens eine Anzahl von HF2-Signalen gezählt wurde, die größer oder gleich der vierten Störlichtbogen-Anzahl ist, ein Störlichtbogen gemeldet. In beiden Fällen werden lediglich die HF2-Signale innerhalb des Parallelzeitraums gezählt, deren zeitlicher Abstand zu dem jeweiligen direkt vorhergehenden HF2-Signal größer als der ersten Störlichtbogen-Zeitspanne ist, und der Störlichtbogen wird erst gemeldet, wenn einer der Abstände größer oder gleich der zweiten Störlichtbogen-Zeitspanne ist.

Mit anderen Worten wird der Parallelzeitraum gestartet, falls ein NF2-Signal gemessen wird, das länger als die NF2-Grenzlänge andauert. Mit dem Parallelzeitraum beginnt ebenfalls jedes Mal die dritte Störlichtbigen-Zeitspanne. Der Parallelzeitraum wird immer dann beendet, falls entweder ein NF2-Signal gemessen wird, dessen Länge kürzer als die NF2-Grenzlänge ist, oder falls die elektrische Spannung des Stromkreises für die erste Abbruch-Zeitspanne kleiner als die Abbruch-Spannung war, oder falls für einen Zeitraum, der die Länge der zweiten Abbruch-Zeitspanne aufweist, kein NF2-Signal gemessen wurde.

Falls innerhalb der dritten Störlichtbogen-Zeitspanne eine Anzahl NF2-Signale, die zwischen einschließlich der zweiten Störlichtbogen-Anzahl und der dritten Störlichtbogen-Anzahl liegt, und eine Anzahl HF2-Signale, die größer oder gleich der ersten Störlichtbogen-Anzahl ist, gemessen werden, so wird ein Störlichtbogen gemeldet. Falls die Anzahl der innerhalb der dritten Störlichtbogen-Zeitspanne gemessen NF2-Signale größer als die dritte Störlichtbogen-Anzahl ist, so wird ein Störlichtbogen gemeldet, wenn die Anzahl der während des Parallelzeitraums registrierten HF2-Signale die vierte Störlichtbogen-Anzahl übersteigt. Geeigneterweise ist die dritte Störlichtbogen-Anzahl größer als die zweite Störlichtbogen-Anzahl.

Der Störlichtbogen wird in beiden Fällen jedoch nur dann gemeldet, wenn der zeitliche Abstand jeweils zweier direkt aufeinanderfolgender HF2-Signale innerhalb des Parallelzeitraums größer oder gleich der ersten Störlichtbogen-Zeitspanne und einer der Abstände größer oder gleich der zweiten Störlichtbogen-Zeitspanne ist.

Die den Schutzschalter betreffende Aufgabe wird erfindungsgemäß gelöst durch die Merkmale des Anspruchs 7. Vorteilhafte Weiterbildungen und Ausgestaltungen sind Gegenstand der hierauf bezogenen Unteransprüche.

Mittels des Schutzschalters wird ein elektrischer Stromkreis überwacht, der eine elektrische Spannung, einen elektrischen Strom und eine Netzfrequenz aufweist. Der Schutzschalter ist dazu vorgesehen und eingerichtet zumindest eines der oben beschriebenen Verfahren durchzuführen. Insbesondere weist der Schutzschalter eine Überwachungseinheit für die elektrische Spannung und eine Überwachungseinheit für den elektrischen Strom auf, so dass NF1-Signale, NF2-Signale und/oder HF2-Signale identifiziert werden können. Zweckmäßigerweise sind die Überwachungseinheiten derart ausgestaltet, dass die Signale direkt aus den jeweiligen Messgrößen ermittelt werden können, also die Messgrößen beispielsweise nicht zunächst in den Frequenzraum transferiert und dort analysiert werden müssen. In einer vorteilhaften Ausführungsform der Erfindung ist der Schutzschalter darauf ausgelegt, alle obigen unabhängigen Verfahren durchzuführen. Auf diese Weise kann eine große Anzahl von verschiedenen Störlichtbogenarten erkannt werden,

Geeigneterweise weist der Schutzschalter eine Unterbrechungseinheit auf. Die Unterbrechungseinheit unterbricht den Stromkreis, sobald ein Störlichtbogen gemeldet ist. Auf diese Welse wird der Störlichtbogen beendet, so dass ein unkontrolliertes Entladen einer etwaigen Batterie beendet oder ein thermisches Aufheizen der Komponenten oder der Umgebung des Stromkreises verhindert wird.

Die beschriebenen Verfahren und der Schutzschalter eignen sich insbesondere für einen Stromkreis mit einer Netzfrequenz von 400Hz, wobei auch ein Einsatz bei einer Netzfrequenz zwischen 300Hz und 1kHz vorstellbar ist. Ebenso ist auch eine Anwendung in einem eine kleinere Netzfrequenz aufweisenden Stromkreis bis hin zu einer Anwendung in einem Stromkreis, innerhalb dessen ein Gleichstrom fließt, denkbar. Vorteilhafterweise beträgt die elektrische Spannung des Stromkreises 115V oder zwischen 220V und 230V. Insbesondere wird zumindest eines der Verfahren oder der Schutzschalter innerhalb eines Stromkreises eines Flugzeuges angewandt bzw. kommt dort zum Einsatz.

Nachfolgend wird ein Ausführungsbeispiel der Erfindung anhand einer Zeichnung näher erläutert. Darin zeigen:
- Fig. 1: schematisch einen elektrischen Stromkreis mit einem Schutzschalter,
- Fig. 2: eine Anzahl von NF1- oder NF2-Signalen,
- Fig. 3: eine Anzahl von HF2-Signalen,
- Fig. 4: eine Anzahl von Anhäufungen,
- Fig. 5: ein erstes Verfahren zur Erkennung eines Störlichtbogens,
- Fig. 6: ein zweites Verfahren zur Erkennung eines Störlichtbogens,
- Fig. 7: ein drittes Verfahren zur Erkennung eines Störlichtbogens,
- Fig. 8: ein viertes Verfahren zur Erkennung eines Störlichtbogens, und
- Fig. 9: den zeitlichen Verlauf einer elektrischen Spannung.

Einander entsprechende Teile sind in allen Figuren mit den gleichen Bezugszeichen versehen.

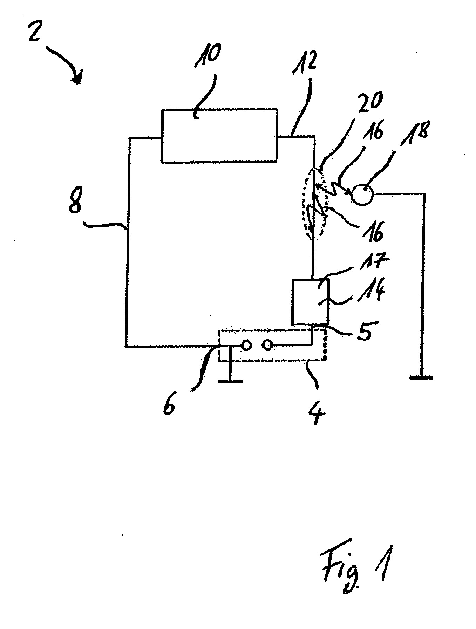

In Fig. 1 ist ein elektrischer Stromkreis 2 dargestellt. Der elektrische Stromkreis 2 umfasst eine elektrische Stromquelle 4 mit zwei Anschlüssen 5, 6, wobei einer der Anschlüsse 6 elektrisch mit Masse verbunden ist. Dieser Anschluss 6 ist über eine elektrische Leitung 8 mit einem Verbraucher 10 elektrisch verbunden. Der Verbraucher 10 ist beispielsweise ein elektrischer Stellmotor, eine Lampe, oder ein Sensor. Mit dem Verbraucher 10 ist über eine weitere elektrische Leitung 12 ein Schutzschalter 14 elektrisch verbunden, wobei der Schutzschalter 14 mit einem der Anschlüsse 5 der Stromquelle 4 verbunden ist. Der Schutzschalter 14 ist darauf ausgelegt, Störlichtbögen 16 innerhalb des elektrischen Stromkreises 2 zu erkennen und nach dem Erkennen den elektrischen Stromkreis 2 mittels einer Unterbrechungseinheit 17 zu unterbrechen. Der Störlichtbogen 16 tritt beispielsweise zwischen der elektrischen Leitung 12 und einem weiteren mit Masse verbundenen Element 18 auf, wobei beispielsweise eine Isolierung der elektrischen Leitung 12 in einem Bereich 20 in der Nähe des mit Masse verbundenen Elements 18 beschädigt ist. Zwischen dem Element 18 und der elektrischen Leitung befindet sich beispielsweise entweder Luft oder eine elektrisch leitende Flüssigkeit, wie insbesondere Salzwasser. Der Störlichtbogen 16 kann auch entlang der elektrischen Leitung 12 auftreten.

Die Stromquelle 4 liefert einen elektrischen Strom 22, der beispielsweise ein sinusförmig verlaufender Wechselstrom ist und eine Nennstromstärke aufweist. Die mittels der Stromquelle 4 erzeugt elektrische Spannung 24 weist einen ähnlichen Verlauf auf, wobei deren Nennspannungswert beispielsweise 115 Volt ist. Die Frequenz des Stromes 22 und die der Spannung sind jeweils gleich einer Netzfrequenz 26, die insbesondere 400 Hz beträgt. Der Stromkreis 2 ist vorzugsweise in einem Flugzeug realisiert. Zweckdienlicherweise liegt der Anschluss 6 auf dem gleichen elektrischen Potential wie die Flugzeugaußenhaut. Ebenso denkbar ist, dass falls der Stromkreis 2 nicht in einem Flugzeug realisiert ist, der Anschluss 6 und das Element 18 geerdet sind.

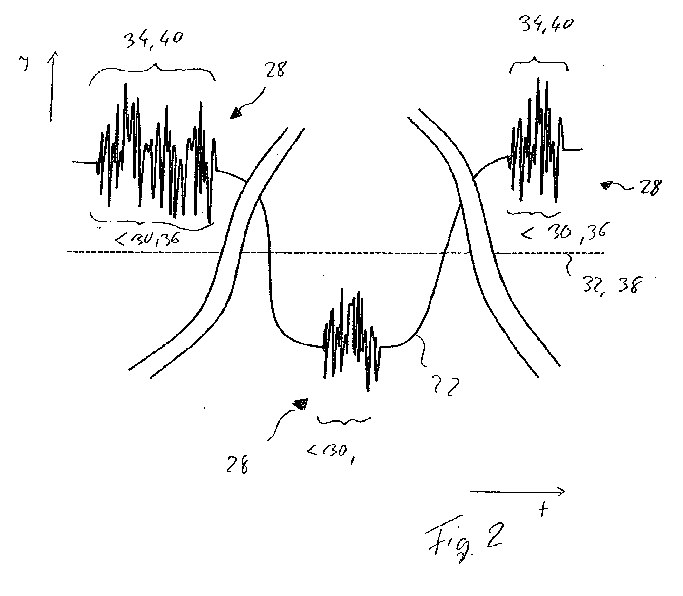

Fig. 2 zeigt eine Anzahl von Störsignalen 28 innerhalb des zeitlichen Verlaufs des elektrischen Stroms 22. Der Verlauf des elektrischen Stroms 22 ist hierbei beispielsweise nicht sinusförmig, sondern vielmehr, insbesondere hinsichtlich einer vergleichsweise einfachen Erläuterbarkeit, rechteckförmig. Dies schränkt jedoch die Erfindung in keinster Weise ein.

Die Frequenz jedes der Signale 28 liegt unterhalb einer NF1-Frequenz 30, die insbesondere 30kHz beträgt. Der elektrische Strom 22 des ersten der Störsignale 28 liegt oberhalb einer NF1-Grenzschwelle 32, welche beispielsweise ein Drittel des Nennstroms beträgt. Dieses Störsignal 28 wird als ein NF1-Signal 34 bezeichnet. Ebenso erfüllt das dritte der Störsingale 28 die beiden Kriterien eines NF1-Signals 34, wonach die Frequenz des Störsignals 28 kleiner als die NF1-Frequenz 30 ist, und wonach der elektrische Strom 22 des Störsignals 28 größer als die NF1-Grenzschwelle 32 ist. Hierbei ist das erste NF1-Signal 34 länger als das zweite NF1-Signal 34, also die zeitliche Länge des ersten NF1-Signals 34 ist größer als die zeitliche Länge des zweiten NF1-Signals 34. Das zweite der Störsignale 28 ist kein NF1-Signal 34, da zwar die Frequenz des Störsignals 28 kleiner als die NF1-Frequenz 30 ist, jedoch auch der elektrische Strom 22 während der Dauer des zweiten Störsignals 28 kleiner als die NF1-Grenzschwelle 32 ist.

Ist sowohl die Frequenz der einzelnen Störsignale 28 kleiner als eine NF2-Frequenz 36, die beispielsweise 400 Hz beträgt und insbesondere gleich der Netzfrequenz 26 ist, als auch der elektrische Strom 22 größer als eine NF2-Grenzschwelle 38, die geeigneterweise gleich dem Nennstrom ist, so werden die Störsignale 28 als NF2-Signale 40 bezeichnet. Der Unterschied zwischen dem NF1-Signal 34 und dem NF2-Signal 40 sind somit lediglich die jeweiligen Schwellen der Frequenz als auch des elektrischen Stroms 22 der jeweiligen Störsignale 28. Insbesondere wird das Störsignal 28, das als NF2-Signal 40 bezeichnet wird, auch als NF1-Signal 34 bezeichnet.

Geeigneterweise analysiert der Schutzschalter 6 den zeitlichen Verlauf des elektrischen Stroms 22 und leitet daraus die Frequenz der etwaigen Störsignale 28 ab. Dies hat im Vergleich zu zum Beispiel einer Fourier-Analyse des Verlaufs des elektrischen Stroms 22 den Vorteil, dass innerhalb eines bestimmten Zeitbereichs die Frequenzen der Störsignale 28 analysiert werden können, ohne etwaige Artefakte aufgrund der zeitlichen Begrenztheit des Zeitbereichs erwarten zu müssen. Weiterhin kann hiermit der Berechnungsaufwand reduziert werden, und es existieren ebenfalls keine Einschränkungen für die Länge des zu analysierenden Zeitbereichs.

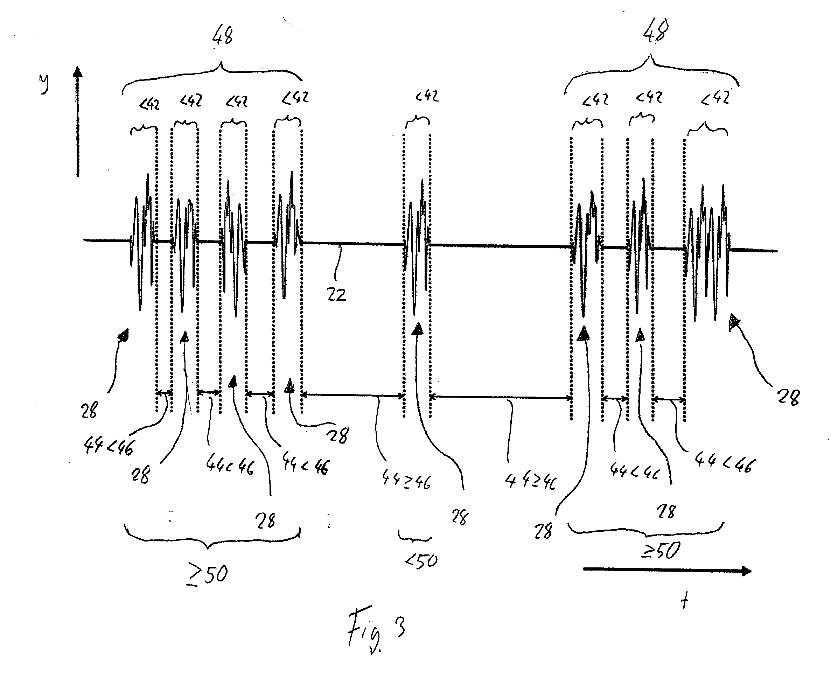

Fig. 3 zeigt einen weiteren zeitlichen Verlauf des elektrischen Stroms 22. Der elektrische Strom 22 umfasst eine Anzahl von Störsignalen 28, wobei die Frequenz jedes der Störsignale 28 kleiner als eine HF2-Frequenz 42 ist. Die HF2-Frequenz 42 beträgt beispielsweise 3,3 MHz. Jedes der Störsignale 28, deren jeweilige Länge variieren kann, weist einen zeitlichen Abstand 44 zu dem jeweiligen vorhergehenden Störsignal 28 auf. Ist für eine Anzahl zeitlich direkt aufeinander folgende Störsignale 28 der jeweilige zeitliche Abstand 44 kleiner als eine HF2-Zeit 46, so werden diese Störsignale 28 zu einem HF2-Signal 48 zusammengefasst, falls die Anzahl der derartigen Störsignale 28 eine HF2-Anzahl 50 überschreitet oder der HF2-Anzahl 50 entspricht. Die HF2-Anzahl 50 ist insbesondere zwei. Beispielsweise umfassen das erste der dargestellten HF2-Signale 48 vier Störsignale 28 und das zweite der dargestellten HF2-Signale 48 drei Störsignale 28, wobei hier das zeitlich letzte der Störsignale 28 eine vergleichsweise große Länge aufweist.

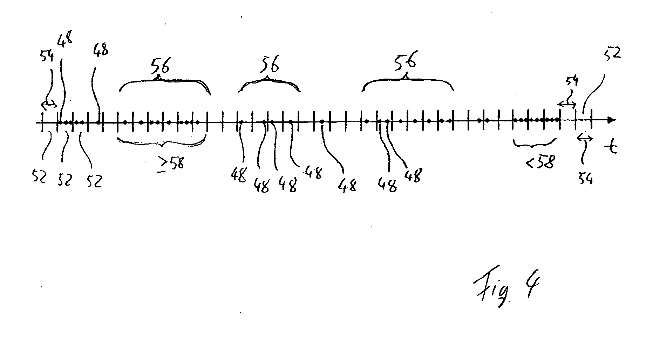

In Fig. 4 ist eine Anzahl von HF2-Signalen 48 dargestellt. Jeweils ein Punkt repräsentiert ein HF2-Signal 48, wobei die Länge der HF2-Signale 48 durchaus variieren kann. Die Zeitspanne, innerhalb der die HF2-Signale 48 gemessen werden, ist in einzelne Zeiträume 52 unterteilt. Insbesondere ist die gesamte Zeitspanne, die der Stromkreis 2 betrieben ist, in die Zeiträume 52 unterteilt. Die Länge jedes der Zeiträume 52 ist gleiche einer Anhäufungs-Länge 54, welche geeigneterweise 100µs beträgt. Alle zeitlich zusammenhängenden Zeiträume 52, innerhalb derer jeweils mindestens ein HF2-Signal 48 registriert wurde, werden zu einer Anhäufung 56 zusammengefasst, falls die Anzahl der derartigen Zeiträume 52 größer oder gleich einer Anhäufungs-Anzahl 58 ist. Die Anhäufungs-Anzahl 58 ist insbesondere gleich vier. Folglich werden mindestens vier jeweils aneinander angrenzende Zeiträume 52 zu einer der Anhäufungen 56 zusammengefasst, falls in jedem der jeweiligen Zeiträume 52 mindestens ein HF2-Signal 48 gemessen wurde. Hierbei kann der zeitliche Abstand zwischen zwei direkt aufeinanderfolgenden HF2-Signalen sowohl größer als auch kleiner als die Anhäufungs-Länge 54 sein, jedoch nicht größer als das doppelte der Anhäufungs-Länge 54. Ebenso können mehrere HF2-Signale 48 innerhalb eines der Zeiträume 52 gemessen worden sein.

Insbesondere ist die Länge jeder der Anhäufungen 56 ein Vielfaches der Anhäufungs-Länge 54. Beispielsweise umfasst der Schutzschalter 14 einen Mikroprozessor, der die HF2-Signale 48 jeweils nur in einem bestimmten zeitlichen Takt verarbeiten kann, der mit der Anhäufungs-Länge 54 korrespondiert. Insbesondere weist der Schutzschalter 14 eine Integrationseinheit auf, die sämtliche HF2-Signale 48 eines einzigen Zeitraums 52 zählt, beispielsweise mittels eines Kondensators, und die nach Ablauf des Zeitraums 52 die gemessene Anzahl an den Mikroprozessor weiterleitet.

Wird in einem der Zeiträume 52 kein HF2-Signal 48 gemessen, wobei innerhalb der direkt zeitlich vorangegangenen Zeiträumen 52, die zeitlich zusammenhängen, jeweils mindestens ein HF2-Signal 48 gemessen wurde, und wobei die Anzahl der derartigen Zeiträume kleiner als die Anhäufungs-Anzahl 58 ist, so sind diese zusammenhängenden Zeiträume 52 keine Anhäufung 56, unabhängig davon, wie viele HF2-Signale 48 insgesamt in den derartigen Zeiträumen 52 gemessen wurden. Insbesondere sind die zeitlich letzten der dargestellten Zeiträume 52, die ein HF2-Signal 48 enthalten, keine Anhäufung 56. Zwar wurden innerhalb der drei Zeiträume 52 neun HF2-Signale 48 registriert, jedoch liegt vor dem ersten und dem letzten jener Zeiträume 52, jeweils ein Zeitraum 52, der kein HF2-Signal 48 enthält. Somit ist die Anzahl der zusammenhängenden Zeiträume 52, die mindestens ein HF2-Signal 48 enthalten lediglich drei. Dagegen erfüllt die zweite der dargestellten Anhäufungen 56 die obigen Kriterien. Zwar umfasst diese Anhäufung 56 lediglich vier HF2-Signale 48, die HF2-Signale 48 liegen jedoch jeweils in einem anderen Zeitraum 52, und die Zeiträume 52 folgen zeitlich direkt aufeinander.

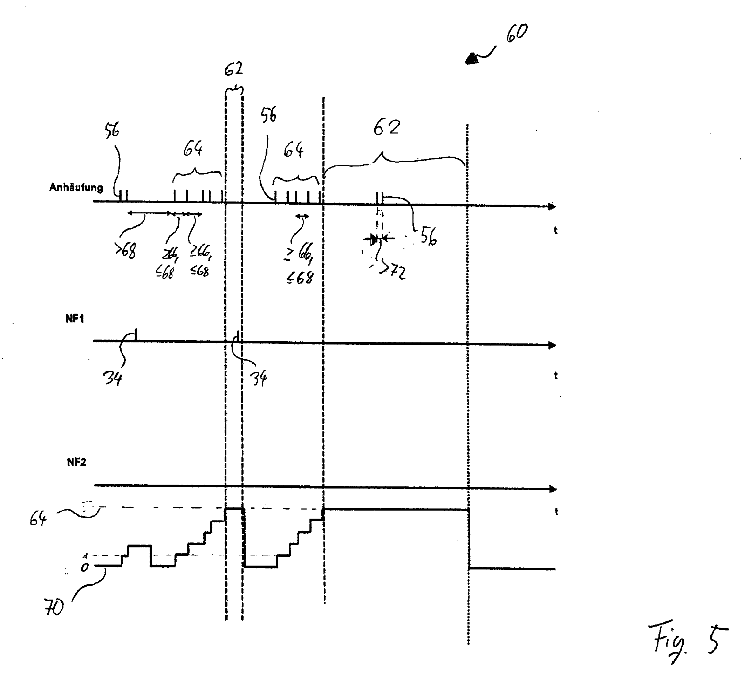

In Fig. 5 ist ein erstes Verfahren 60 zur Erkennung des Störlichtbogens 16 dargestellt. Dieses Verfahren entspricht nicht der vorliegenden Erfindung. Oben ist der zeitliche Verlauf der Messung von einer Anzahl von Anhäufungen 56 innerhalb des Stromkreises 2 dargestellt. Jeder Strich symbolisiert eine Anhäufung 56, wobei die Länge jeder der Anhäufungen 56 variieren kann. Darunter ist der zeitliche Verlauf der Messung von NF1-Signalen 34 und wiederum darunter der der Messung von NF2-Signalen 40 gezeigt. Auch hierbei variiert die Länge der NF1-Signalen 34, wohingegen zum Beispiel kein NF2-Signal 40 gemessen wird.

Falls eine Anzahl von Anhäufungen 56 auftritt, wird eine Warteperiode 62 gestartet, die insbesondere 100ms beträgt. Die Anzahl der Anhäufungen 56, die zu dem Start führen, ist gleich einem Anhäufungswert 64, der insbesondere fünf beträgt. Hierbei ist der zeitliche Abstand zwischen jeweils zweien der Anhäufungen 56 größer oder gleich einer erste Anhäufungs-Zeit 66 und kleiner oder gleich einer zweiten Anhäufungs-Zeit 68. Die erste Anhäufungs-Zeit 66 beträgt beispielsweise 1,6ms und die zweite Anhäufungs-Zeit 68 ist insbesondere 23ms. Geeigneterweise werden die Anhäufungen 56 mittels eines WET1-Anhäufungszählers 70 gezählt. Jeweils zu Beginn des Verfahrens 60 wird der WET1-Anhäufungszählers 70 auf null (0) gesetzt. Für jeden Fall, bei dem der WET1-Anhäufungszähler 70 null (0) beträgt, wird der Zählerstand des WET1-Anhäufungszählers 70 um eins (1) erhöht, sobald eine Anhäufung 56 innerhalb des elektrischen Stroms 22 des Stromkreises 2 erkannt wird. Immer wenn nach einer Erhöhung des WET1-Anhäufungszählers 70 eine weitere Anhäufung 56 folgt, deren zeitlicher Abstand zu der zeitlich vorhergehenden Anhäufung 56 größer oder gleich der erste Anhäufungs-Zeit 66 und kleiner oder gleich der zweiten Anhäufungs-Zeit 68 ist, wird der WET1-Anhäufungszähler 70 ein weiteres Mal erhöht. Ist der zeitliche Abstand zweier aufeinanderfolgender Anhäufungen 56 kleiner oder größer als die erste Anhäufungs-Zeit 66 bzw. die zweite Anhäufungs-Zeit 68, wird der WET1-Anhäufungszähler auf null (0) zurückgesetzt.

Nach dem Erreichen des Anhäufungswertes 64 durch den Zählerstand des WET1-Anhäufungszählers 70 wird die Warteperiode 62 gestartet. Falls innerhalb der Warteperiode 64 ein NF1-Signal 34 gemessen wird oder zwei aufeinanderfolgende Anhäufungen 56 einen zeitlichen Abstand aufweisen, der kleiner als eine dritte Anhäufungs-Zeit 72 ist, so wird die Warteperiode 62 abgebrochen und der WET1-Anhäufungszähler 70 auf null (0) gesetzt. Geeigneterweise ist die dritte Anhäufungs-Zeit 72 gleich 1,5ms. Anhäufungen 56, die einen zeitlichen Abstand aufweisen, der größer als die dritte Anhäufungs-Zeit 72 ist, haben beispielsweise keinen Einfluss auf die Warteperiode 62 und den WET1-Anhäufungszählers 70.

Nachdem Abbruch der Warteperiode 62 wird bei jeder weiteren Anhäufung 56 der WET1-Anhäufungszähler um eins (1) erhöht, solange die Anhäufungen 56 die obigen Kriterien erfüllen. Falls innerhalb der Warteperiode 62 kein NF1-Signal 34 gemessen wird, und etwaige Anhäufungen 56 einen zeitlichen Abstand aufweisen, der größer als die dritte Anhäufungs-Zeit 72 ist, wird eine Meldung 74 des Störlichtbogens 16 ausgegeben.

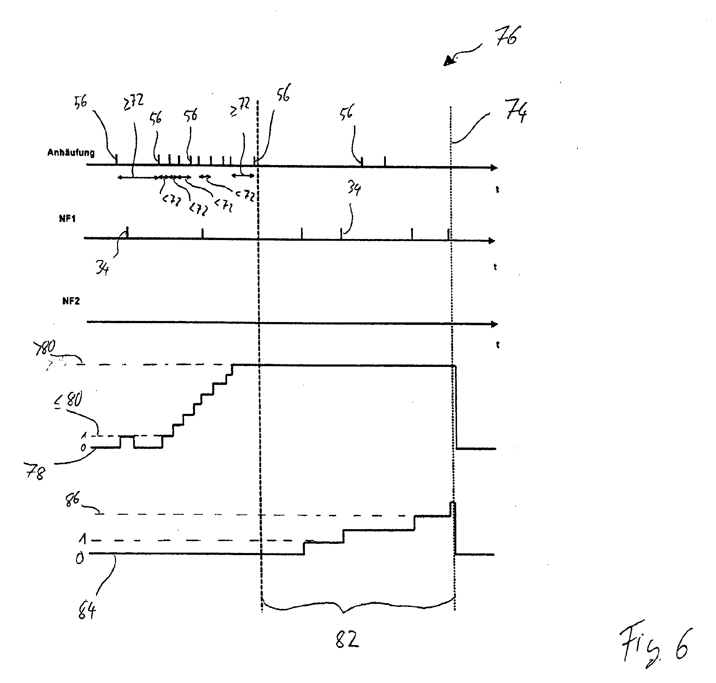

Fig. 6 zeigt ein Verfahren 76 zur Erkennung des Störlichtbogens 16 gemäß der Erfindung. Bei diesem Verfahren 76 werden die in dem elektrischen Strom 22 vorhandenen Anhäufungen 56 gezählt. Im Gegensatz zu dem obigen Verfahren 60 werden bei diesem Verfahren 76 nur die Anhäufungen 56 gezählt, deren zeitlicher Abstand kleiner als die dritte Anhäufungs-Zeit 72 ist.

Zweckmäßigerweise wird hierbei ein WET2-Anhäufungszähler 78 verwendet. Zu Beginn des Verfahrens 76 wird der Zählerstand des WET2-Anhäufungszählers 78 auf null (0) gesetzt. Jedes Mal wenn der WET2-Anhäufungszähler 78 null (0) beträgt wird der Zählerstand des WET2-Anhäufungszählers 78 um eins (1) erhöht, sobald eine Anhäufung 56 innerhalb des elektrischen Stroms 22 des Stromkreises 2 erkannt wird. Bei jeder weiteren identifizierten Anhäufung 56, deren zeitlicher Abstand zu der zeitlich direkt vorrangegangenen Anhäufung 56 kleiner als die dritte Anhäufungs-Zeit 72 ist, wird der WET2-Anhäufungszählers 78 um eins (1) erhöht. Sobald eine Anhäufung 56 einen zeitlichen Abstand zu der vorherigen Anhäufung 56 aufweist, der größer als die dritte Anhäufungs-Zeit 72 ist, wird der WET2-Anhäufungszählers 78 überprüft. Ist der Zählerstand kleiner oder gleich einem ersten WET2-Grenzwert 80, so wird der WET2-Anhäufungszählers 78 auf null (0) zurückgesetzt. Übersteigt der WET2-Anhäufungszählers 78 den ersten WET2-Grenzwert 80, so wird eine NF-Periode 82 gestartet. Der erste WET2-Grenzwert 80 ist geeigneterweise sechs und die NF-Periode 82 ist insbesondere 20ms.

Innerhalb der NF-Periode 82 wird ein NF1-Zähler 84 aktiv. Zu Beginn der NF-Periode 82 wird der NF1-Zähler 84 auf null (0) gesetzt, und mit jedem innerhalb der NF-Periode 82 gemessenen NF1-Signal 34 um eins (1) erhöht. Überschreitet der NF1-Zähler 84 einen zweiten WET2-Grenzwert 86, so wird die Meldung 74 des Störbogens 16 ausgegeben und insbesondere die NF-Periode 82 beendet. Vorteilhafterweise ist der zweite WET2-Grenzwert 86 gleich drei. Falls nach der NF-Periode 82 die Anzahl der gemessenen NF1-Signale 34 kleiner oder gleich dem zweiten WET2-Grenzwert 86 ist, werden der NF1-Zähler 84 und der WET2-Anhäufungszählers 78 auf null (0) gesetzt und das Verfahren 76 neugestartet.

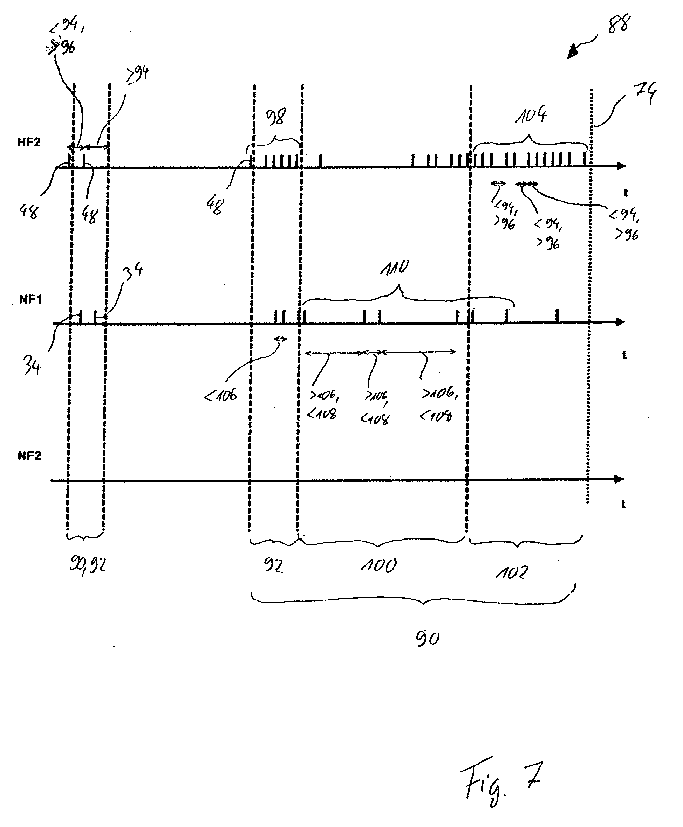

Eine zweckmäßige Weiterentwicklung 88 des Verfahrens zur Erkennung des Störlichtbogens 16 ist in Fig. 7 dargestellt. Oben ist der zeitliche Verlauf der Messung von einer Anzahl der HF2-Signale 48 innerhalb des Stromkreises 2 dargestellt. Jeder Strich symbolisiert eines der HF2-Signale 48, wobei die Länge jedes der HF2-Signale 48 variieren kann. In der Mitte ist der zeitliche Verlauf der Messung der NF1-Signale 34 und unten der zeitliche Verlauf der Messung von NF2-Signalen 40 gezeigt. Auch hierbei variiert die Länge der NF1-Signalen 34, wohingegen zum Beispiel kein NF2-Signal 40 gemessen wird.

Jedes in dem elektrischen Strom 22 vorhandene HF2-Signal 48, das außerhalb eines Seriellzeitraums 90 gemessen wurde, startet einen Seriellzeitraum 90, welcher mit einer ersten Messphase 92 beginnt. Das den Seriellzeitraum 90 startende HF2-Signal 48 zählt zu dem Seriellzeitraum 90 sowie zur ersten Messphase 92 und ist lediglich zur Verdeutlichung zeitlich geringfügig früher dargestellt. In der ersten Messphase 92 werden die etwaigen, in dem elektrischen Strom 22 vorhandenen HF2-Signale 48 gezählt. Hierbei werden jedoch nur die HF2-Signale 48 gezählt, deren zeitlicher Abstand zu dem jeweiligen, zeitlich direkt vorangegangenen HF2-Signal 48 zwischen einer dritten Abbruch-Zeitspanne 94 und einer vierten Abbruch-Zeitspanne 96 liegt. Vorzugsweise ist die dritte Abbruch-Zeitspanne 94 gleich 200ms und die vierten Abbruch-Zeitspanne 96 beträgt zum Beispiel 300µs.

Falls innerhalb der ersten Messphase 92 der zeitliche Abstand zwischen zwei zeitlich direkt aufeinanderfolgenden HF2-Signalen 48 größer als die dritte Abbruch-Zeitspanne 94 ist, wird sowohl die ersten Messphase 92 als auch der Seriellzeitraum 90 abgebrochen. Mit anderen Worten wird die erste Messphase 92 und der Seriellzeitraum 90 abgebrochen, wenn für die dritte Abbruch-Zeitspanne 94 nach dem zeitlich letzten HF2-Signal 48 kein weiteres HF2-Signal gemessen wird. Dies ist beispielsweise nach dem zweiten der dargestellten HF2-Signale 48 der Fall.

Wird innerhalb der ersten Messphase 92 eine Anzahl von HF2-Signalen 48 einschließlich des den Start des Seriellzeitraums 90 bewirkenden HF2-Signals 48 gezählt, welche Anzahl gleich einer ersten Seriellen-Anzahl 98 ist, so wird die erste Messphase 92 beendet und eine Halteperiode 100 gestartet. Die erste Seriellen-Anzahl 98 ist zum Beispiel sechs. Innerhalb der Halteperiode 100 werden insbesondere etwaige gemessene HF2-Signale 48 nicht berücksichtigt. Das bedeutet, dass weder deren Anzahl, noch deren jeweilige Länge oder der zeitliche Abstand zwischen zwei HF2-Signalen 48 eine Auswirkung auf die Halteperiode 100 haben. Die Halteperiode 100 ist geeigneterweise zwischen 30ms und 220ms lang. Beispielsweise ist die Länge der Halteperiode 100 von der Größe des elektrischen Stroms 22 und insbesondere von dessen Nennstrom abhängig. Bei einem vergleichsweise großen Nennstrom ist die Halteperiode 100 zum Beispiel größer als bei einem vergleichsweise kleinen Nennstrom. Vorteilhafterweise ist die Länge der Halteperiode 100 während des Betriebs des elektrischen Stromkreises 2 veränderbar.

An die Halteperiode 100 schließt sich direkt eine zweite Messphase 102 an. Innerhalb der zweiten Messphase 102 werden, vergleichbar mit der ersten Messphase 98, diejenigen HF2-Signale 48 gezählt, deren zeitlicher Abstand zu dem jeweiligen, zeitlich direkt vorangegangenen HF2-Signal 48 zwischen der dritten Abbruch-Zeitspanne 94 und der vierten Abbruch-Zeitspanne 96 liegt. Ebenso wird auch die zweiten Messphase 102 und der Seriellzeitraum 90 abgebrochen, falls innerhalb der zweiten Messphase 102 der zeitliche Abstand zwischen zwei zeitlich direkt aufeinanderfolgenden HF2-Signalen 48 größer als die dritte Abbruch-Zeitspanne 94 ist.

Die zweite Messphase 102 wird beendet, falls innerhalb der zweiten Messphase 102 die Anzahl der gemäß obiger Beschreibung gezählten HF2-Signale 48 einer zweiten Seriellen-Anzahl 104 entspricht. Vorzugsweise ist die zweite Seriellen-Anzahl 104 gleich zwölf. Mit der zweiten Messphase 102 wird auch der Seriellzeitraum 90 beendet. Nach dem Beenden der zweiten Messphase 102 werden die innerhalb des gesamten Seriellzeitraums 90 gezählten NF1-Signale 34 überprüft, deren zeitlicher Abstand zueinander zwischen einer fünften Abbruch-Zeitspanne 106 und einer sechsten Abbruch-Zeitspanne 108 liegt. Die fünfte Abbruch-Zeitspanne 106 ist vorteilhafterweise gleich 8,3ms und die sechste Abbruch-Zeitspanne 108 beträgt zweckmäßigerweise 200ms. Ist die Anzahl der derartigen NF1-Signale 34 größer als eine dritte Seriellen-Anzahl 110, so wird der Störlichtbogen 16 gemeldet.

Geeigneterweise ist die dritte Seriellen-Anzahl 110 gleich sechs. Die Meldung 74 des Störlichtbogens wird ebenfalls ausgegeben, falls die Anzahl der derartigen NF1-Signale 34 gleich der dritte Seriellen-Anzahl 110 ist, und nach dem zeitlich letzten der derartigen NF1-Signale 34 für zumindest einen Zeitraum, der größer oder gleich der fünften Abbruch-Zeitspanne 106 ist, kein weiteres NF1-Signal 34 in dem elektrischen Strom 22 gemessen wurde.

Innerhalb des zweiten der dargestellten Seriellzeiträume 90 sind sieben derartige NF1-Signale 34 gezeigt. Beispielsweise weisen die beiden ersten NF1-Signale 34 des zweiten Seriellzeitraums 90 einen zeitlichen Abstand zueinander auf, der kleiner als die fünfte Abbruch-Zeitspanne 106 ist, weswegen diese beiden NF1-Signale 34 bei der Überprüfung nicht berücksichtigt werden. Der jeweilige zeitliche Abstand aller weiteren NF1-Signale 34 des zweiten Seriellzeitraums 90 liegt hingegen zwischen der fünften Abbruch-Zeitspanne 106 und der sechsten Abbruch-Zeitspanne 108.

Etwaige vor oder nach den derartigen NF1-Signalen 34 innerhalb des Seriellzeitraums 90 zusätzlich gemessene NF1-Signale 34 haben vorzugsweise keine Auswirkung auf die Meldung 74 des Störlichtbogens 16.

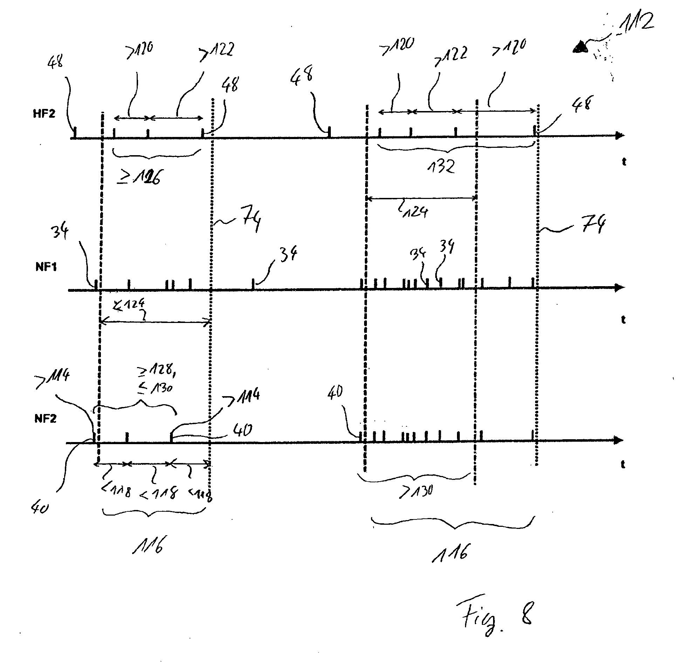

Fig. 8 zeigt ein weiteres Verfahren 112 zur Erkennung des Störlichtbogens 16 gemäß Fig.7. Sobald ein NF2-Signal 40, dessen Länge größer als eine NF2-Grenzlänge 114 ist, außerhalb eines Parallelzeitraums 116 gemessen wird, wird der Parallelzeitraum 116 gestartet. Auch hierbei zählt - vergleichbar mit dem in Fig. 7 dargestellten Verfahren 88 - das den Parallelzeitraum 116 startende NF2-Signal 40 zu dem Parallelzeitraum 116. Die NF2-Grenzlänge 114 ist zum Beispiel gleich 200µs. Während des Parallelzeitraums 116 werden alle NF2-Signale 40 gezählt, deren Länge größer als die oder gleich der NF2-Grenzlänge 114 ist, und der Parallelzeitraums 116 wird abgebrochen, falls eine der Längen der NF2-Signale 40 kleiner als die NF2-Grenzlänge 114 ist. Der Parallelzeitraum 116 wird ebenfalls abgebrochen, falls für eine zweite Abbruch-Zeitspanne 118 innerhalb des Parallelzeitraums 116 kein NF2-Signal 40 gemessen wird. Insbesondere ist die zweite Abbruch-Zeitspanne 118 gleich 500ms. Ebenso führt eine elektrische Spannung 24, die während des Parallelzeitraums 116 für eine erste Abbruch-Zeitspanne kleiner als eine Abbruch-Spannung ist, zu einem Abbruch des Parallelzeitraums 116. Hierbei ist beispielsweise die Abbruch-Spannung gleich 15V und die erste Abbruch-Zeitspanne beträgt insbesondere 3,2ms.

Zusätzlich zu den NF2-Signalen 40 werden innerhalb des Parallelzeitraums 116 die HF2-Signale 48 gezählt, deren zeitlicher Abstand zu dem jeweiligen, zeitlich direkt vorangegangenen HF2-Signal 48 größer oder gleich einer ersten Störlichtbogen-Zeitspanne 120 ist, welche insbesondere 500µs beträgt. Ferner wird überprüft, ob einer der Abstände größer als eine zweite Störlichtbogen-Zeitspanne 122 ist. Falls dies der Fall ist, und sowohl die Anzahl der insgesamt innerhalb einer dritten Störlichtbogen-Zeitspanne 124 gemessenen HF2-Signale 48 größer oder gleich einer ersten Störlichtbogen-Anzahl 126 ist, als auch die Anzahl der innerhalb der dritten Störlichtbogen-Zeitspanne 124 gemessen NF2-Signale 40 größer oder gleich einer zweiten Störlichtbogen-Anzahl 128 und kleiner oder gleich einer dritten Störlichtbogen-Anzahl 130 ist, wird der Störlichtbogen 16 gemeldet. Die dritte Störlichtbogen-Zeitspanne 124 beginnt mit dem Parallelzeitraum 116 und ist geeigneterweise 25ms lang. Beispielsweise ist die erste Störlichtbogen-Anzahl 126 drei, die zweite Störlichtbogen-Anzahl 128 ist insbesondere drei, und die dritte Störlichtbogen-Anzahl 130 ist vorzugsweise sieben.

In der Figur 8 weisen beispielsweise alle NF2-Signale 40 eine zeitliche Länge auf, die größer als die NF2-Grenzlänge 114 ist, und mit dem zeitlich ersten NF2-Signal 40 wird der erste der beiden dargestellten Paralleizeitraum 116 gestartet. Innerhalb dieses Parallelzeitraums 116 werden einschließlich des NF2-Signals 40, das den Start dieses Parallelzeitraums 116 auslöst, drei NF2-Signale 40 gemessen, wobei diese Anzahl der zweiten Störlichtbogen-Anzahl 128 entspricht. Während des Parallelzeitraums 116 werden ebenfalls drei HF2-Signale 48 gemessen, wobei diese Anzahl gleich der ersten Störlichtbogen-Anzahl 126 ist. Der Abstand zwischen dem ersten und dem zweiten der HF2-Signale 48 ist größer als die erste Störlichtbogen-Zeitspanne 120, und der Abstand zwischen dem zweiten und dem dritten der HF2-Signale 48 ist größer als die zweite Störlichtbogen-Zeitspanne 122. Da innerhalb der dritten Störlichtbogen-Zeitspanne 124 drei NF2-Signale 40 gemessen wurden, wird nach dem zeitlich letzten der drei HF2-Signale 48 sowohl der Parallel zeitraum 116 beendet als auch der Störlichtbogen 16 gemeldet.

Das vierte der NF2-Signale 40 startet den zweiten der dargestellten Paralleizeiträume 116. Die zeitliche Abfolge der innerhalb des zweiten der Parallelzeiträume 116 gemessenen HF2-Signale 48 ist zum Beispiel gleich der zeitlichen Abfolge der innerhalb des ersten der Parallelzeiträume 116 gemessenen HF2-Signale 48. Innerhalb der dritten Störlichtbogen-Zeitspannen 124 werden einschließlich des NF2-Signals 40, das den Start des zweiten der Parallelzeiträume 116 auslöst, neun NF2-Signale 40 gemessen. Diese Anzahl ist größer als die dritte Störlichtbogen-Anzahl 130, weswegen nach dem dritten der innerhalb des zweiten der Parallelzeiträume 116 gemessenen Hf2-Signale 48 der zweite Parallelzeitraum 116 nicht beendet wird. Erst wenn eine Anzahl von HF2-Signalen 40 gemessen wurde, die einer vierten Störlichtbogen-Anzahl 132 entspricht, wird der Störlichtbogen 16 gemeldet. Die vierte Störlichtbogen-Anzahl 132 ist insbesondere vier, weswegen nach dem Messen des vierten HF2-Signals 48 des zweiten Parallelzeitraums 116 die Meldung 74 des Störlichtbogens 16 ausgegeben wird, wobei der zeitliche Abstand dieses HF2-Signals 48 zu dessen zeitlich direkt vorangegangenem HF2-Signal 48 größer oder gleich der ersten Störlichtbogen-Zeitspanne 120 ist.

Geeigneterweise kann dieses Verfahren 112 abwechselnd mit zumindest einem weiteren, vorzugsweise allen, der obigen Verfahren 60, 76, 88 ablaufen. Hierbei wird das weitere Verfahren unterbrochen, wenn eines der NF2-Signal 40 gemessen wird, dessen Länge größer als die NF2-Grenzlänge 114 ist. Während des Parallelzeitraums 116 wird das weitere Verfahren angehalten, was bedeutet, dass mit Ausnahme der für das Verfahren 112 benötigten Signale, nämlich die HF2-Signale 48 und die NF2 Signale 40, kein weiteres Signal wie zum Beispiel die NF1-Signale 34 oder die Anhäufungen 56 weiterverarbeitet werden. Die HF2-Signale 48 werden zudem lediglich insofern berücksichtigt, als sie zu dem Verfahren 112 beitragen. Insbesondere werden weder der WET1-Anhäufungszähler 70, noch der WET2-Anhäufungszähler 78 oder der NF1-Zähler 84 innerhalb des Parallelzeitraums 116 verändert. Nach dem Abbruch oder der Beendigung des Parallelzeitraums 116 wird das weitere Verfahren neu gestartet, was insbesondere ein Zurücksetzen des oder der jeweiligen Zähler auf null (0) zur Folge hat.

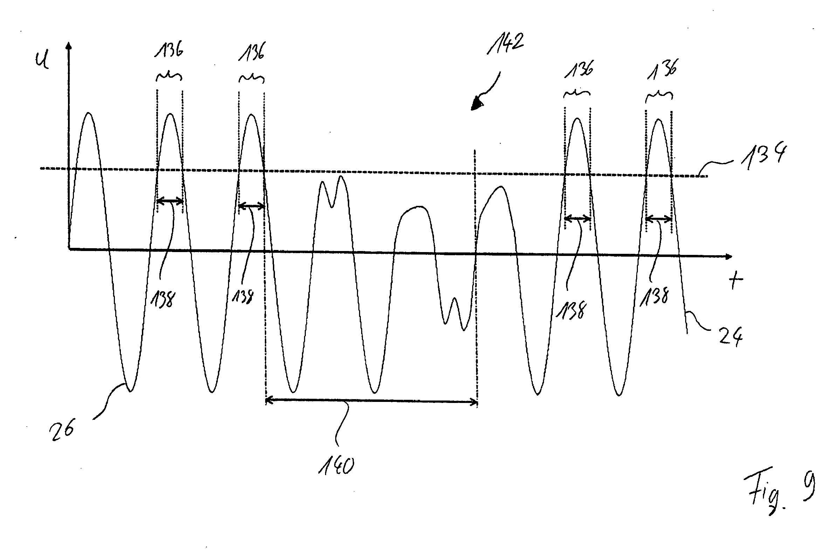

In Fig. 9 ist der zeitliche Verlauf der elektrischen Spannung 24 dargestellt, welcher im Wesentlichen sinusförmig ist. Aufgrund der zeitlichen Periodizität der elektrischen Spannung 24 überschreitet diese im Normalbetrieb regelmäßig einen Grenzwert, der als SPG-Spannung 134 bezeichnet wird. Die SPG -Spannung 134 ist kleiner als die Nennspannung und beträgt vorzugsweise 90V. Der Zeitraum, innerhalb dessen die elektrische Spannung 24 größer als die SPG -Spannung 134 ist, wird als eine Hochzeitspanne 136 bezeichnet. Im Normalbetrieb ist die Länge 138 aller Hochzeitspannen 136 im Wesentlichen gleich und konstant sowie zudem abhängig von der Netzfrequenz 26. Beispielsweise beträgt die Länge 138 im Normalbetrieb 600µs. Ebenfalls ist der zeitliche Abstand zwischen den einzelnen Hochzeitspannen 136 im Wesentlichen gleich und konstant sowie abhängig von der Netzfrequenz 26. Der zeitliche Abstand im Normalbetrieb ist reziprok zur Netzfrequenz 26 - also 2,5ms - abzüglich der Länge 138 der Hochzeitspanne 136. Insbesondere ist der zeitliche Abstand 1,9ms.

Treten zum Beispiel eines oder mehrere der Störsignale 28 oder der Störlichtbogen 16 auf, oder ist die Leistungsentnahme des Verbrauchers 10 zeitlich wechselhaft, so ist es möglich, dass der Verlauf der elektrischen Spannung 24 von der Sinusform abweicht. Beispielsweise haben derartige Beeinflussungen der elektrischen Spannung 24 zur Folge, dass die Frequenz der elektrischen Spannung 24 gestört wird, also dass die Frequenz nicht konstant ist, oder dass das Maximum der elektrischen Spannung 24 für einen Zeitraum, der größer als das Doppelte des Reziproken der Netzfrequenz 26 ist, kleiner als die Nennspannung ist. Falls sich daher die Längen 138 zweier aufeinanderfolgender Hochzeitspannen 136 um mehr als eine dritte SPG-Zeitspanne unterscheiden, oder für eine zweite SPG-Zeitspanne 140 die elektrische Spannung 24 nicht die SPG -Spannung 134 überschreitet, ist ein Problem der elektrischen Spannung 24 identifiziert, welches als SPG-Fehler 142 bezeichnet wird. Die dritte SPG-Zeitspanne ist geeigneterweise 100µs und die zweite SPG-Zeitspanne beträgt insbesondere 6,4ms.

Vorteilhafterweise wird in Fällen, in denen ein SPG-Fehler 142 innerhalb der elektrischen Spannung 24 identifiziert wird, zumindest eines der obigen Verfahren 76, 88 abgebrochen und für einen Zeitraum, der eine Länge einer ersten SPG-Zeitspanne aufweist, nicht erneut gestartet. Insbesondere werden weder der WET2-Anhäufungszähler 78 noch der NF1-Zähler 84 innerhalb der ersten SPG-Zeitspanne nach dem SPG-Fehler 140 verändert. Nach der ersten SPG-Zeitspanne werden das oder die Verfahren 76, 88 neu gestartet, was insbesondere ein Zurücksetzen der jeweiligen Zähler auf null (0) zur Folge hat. Die SPG-Zeitspanne beträgt geeigneterweise 1s.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den verschiedenen Ausführungsbeispielen beschriebenen Einzelmerkmale auch auf andere Weise miteinander kombinierbar, ohne den Gegenstand der Erfindung zu verlassen.

**Bezugszeichenliste**

| | | | |
|---|---|---|---|
| 2 | Stromkreis | 56 | Anhäufung |
| 4 | Stromquelle | 58 | Anhäufungs-Anzahl |
| 5 | Anschluss | 60 | Verfahren |
| 6 | Anschluss | 62 | Warteperiode |
| 8 | elektrische Leitung | 64 | Anhäufungswert |
| 10 | Verbraucher | 66 | erste Anhäufungs-Zeit |
| 12 | elektrische Leitung | 68 | zweite Anhäufungs-Zeit |
| 14 | Schutzschalter | 70 | WET1-Anhäufungszähler |
| 16 | Störlichtbogen | 72 | dritte Anhäufungs-Zeit |
| 17 | Unterbrechungseinheit | 74 | Meldung |
| 18 | mit Masse verbundenes Element | 76 | Verfahren |
| 20 | Bereich poröser Isolierung | 78 | WET2-Anhäufungszähler |
| 22 | Strom | 80 | erster WET2-Grenzwert |
| 24 | Spannung | 82 | NFPeriode |
| 26 | Netzfrequenz | 84 | NF1-Zähler |
| 28 | Störsignal | 86 | zweiter WET2-Grenzwert |
| 30 | NF1-Frequenz | 88 | Verfahren |
| 32 | NF1-Grenzschwelle | 90 | Seriellzeitraum |
| 34 | NF1-Signal | 92 | erste Messphase |
| 36 | NF2-Frequenz | 94 | dritte Abbruch-Zeitspanne |
| 38 | NF2-Grenzschwelle | 96 | vierte Abbruch-Zeitspanne |
| 40 | NF2-Signal | 98 | erste Seriellen-Anzahl |
| 42 | HF2-Frequenz | 100 | Halteperiode |
| 44 | zeitlicher Abstand | 102 | zweite Messphase |
| 46 | HF2-Zeit | 104 | zweite Seriellen-Anzahl |
| 48 | HF2-Signal | 106 | fünfte Abbruch-Zeitspanne |
| 50 | HF2-Anzahl | 108 | sechste Abbruch-Zeitspanne |
| 52 | Zeitraum | 110 | dritte Seriellen-Anzahl |
| 54 | Anhäufungs-Länge | 112 | Verfahren |
| 114 | NF2-Grenzlänge | | |
| 116 | Parallelzeitraum | | |
| 118 | zweite Abbruch-Zeitspanne | | |
| 120 | erste Störlichtbogen-Zeitspanne | | |
| 122 | zweite Störlichtbogen-Zeitspanne | | |
| 124 | dritte Störlichtbogen-Zeitspanne | | |
| 126 | erste Störlichtbogen-Anzahl | | |
| 128 | zweite Störlichtbogen-Anzahl | | |
| 130 | dritte Störlichtbogen-Anzahl | | |
| 132 | vierte Störlichtbogen-Anzahl | | |
| 134 | SPG -Spannung | | |
| 136 | Hochzeitspanne | | |
| 138 | Länge | | |
| 140 | zweite SPG-Zeitspanne | | |
| 142 | SPG -Fehler | | |

## Patentansprüche

1. Verfahren (76) zur Erkennung von Störlichtbögen (16) Innerhalb eines eine Netzfrequenz (26), einen elektrischen Strom (22) und eine elektrische Spannung (24) aufweisenden Stromkreises (2),
- bei dem ein auftretendes Störsignal (28), das eine Frequenz unterhalb einer NF1-Frequenz (30) und eine Stromstärke des elektrischen Stroms des Stromkreises oberhalb einer NF1-Grenzschwelle (32) aufweist, ein NF1Signal (34) definiert,
- bei dem eine Anzahl von auftretenden Störsignalen (28), die eine Frequenz unterhalb einer HF2-Frequenz (42) aufweisen, zu einem HF2-Signal (48) zusammengefasst werden, falls die Anzahl der auftretenden Störsignale (28) größer oder gleich einer HF2-Anzahl (50) und der zeitliche Abstand zweier aufeinanderfolgender Störsignale (28) kleiner als eine HF2-Zeit (46) ist,
- bei dem eine Anzahl von Zeiträumen (52), deren jeweilige Länge eine Anhäufungs-Länge (54) beträgt und die zeitlich direkt aufeinanderfolgen sowie innerhalb derer jeweils mindestens ein HF2-Signal (48) liegt, eine Anhäufung (56) definieren, wenn die Anzahl der Zeiträume (52) größer oder gleich einer Anhäufungs-Anzahl (58) ist,
- bei dem ein WET2-Anhäufungszähler (78) um eins (1) erhöht wird, falls eine Anhäufung (56) identifiziert wird,
- bei dem bei einem Abstand zweier Anhäufungen (56) zueinander, welcher Abstand der größer oder gleich einer (dritten) Anhäufungs-Zeit (72) list, entweder eine NF-Periode (82) gestartet wird, falls der WET2-Anhäufungszähler (78) größer als ein erster WET2-Grenzwert (80) ist, oder der WET2-Anhäufungszähler (78) auf null(0) zurückgesetzt wird, falls der WET2-Anhäufungszähler (78) kleiner oder gleich dem ersten WET2-Grenzwert ist (80),
- bei dem ein NF1-Zähler (84) um eins (1) erhöht wird, falls innerhalb der NF-Periode (82) ein NF1-Signal (34) gemessen wird,
- bei dem der Störlichtbogen (16) erkannt und/oder gemeldet wird, falls innerhalb der NF-Periode (82) der NF1-Zähler (84) einen zweiten WET2-Grenzwert (86) überschreitet, und
- bei dem nach Ablauf der NF-Periode (82) der WET2-Anhäufungszähier (78) und der NF1-zähler (84) auf null (0) zurückgesetzt werden.

2. Verfahren nach Anspruch 1, bei dem die NF-Periode (82) abgebrochen wird, falls diese bereits begonnen hat, der WET2-Anhäufungszähler (78) und der NF1-Zähler (84) auf null (0) zurückgesetzt und diese für eine erste SPG-Zeitspanne auf null (0) belassen werden, wenn entweder für eine zweite SPG-Zeitspanne (140) die Spannung (24) nicht größer als eine SPG-Spannung (134) ist, oder sich die Längen zweier aufeinanderfolgender Hochzeitspannen (136) um mehr als eine dritte SPG-Zeitspanne unterscheiden, wobei die Hochzeitspannen (136) die Zeitspanne Ist, Innerhalb der die Spannung (24) größer als die SPG-Spannung (134) ist.

3. Verfahren, nach Anspruch 1 oder 2, bei dem die NF-Periode (82) abgebrochen wird, falls diese bereits begonnen hat, der WET2-Anhäufungszähler (78) und der NF1-Zähler (84) auf null (0) zurückgesetzt und für einen Parallelzeitraum (116) auf null (0) belassen werden, falls ein NF2-Signal (40) gemessen wird, das länger als eine NF2-Grenzlänge (114) andauert,
- wobei ein auftretendes Störsignal (28), das eine Frequenz unterhalb einer NF2-Frequenz (36) und eine Stromstärke des elektrischen Stroms des Stromkreises oberhalb einer NF2-Grenzschwelle (38) aufweist, als NF2-Signal (40) bezeichnet wird, und
- wobei der Parallelzeitraum (116) beendet wird, wenn
∘ ein gemessenes NF2-Signal (40) kürzer als die NF2-Grenzlänge (114) andauert, oder
∘ die Spannung (24) für eine ersten Abbruch-Zeitspanne kleiner einer Abbruch-Spannung war, oder
∘ wenn für eine zweite Abbruch-Zeitspanne (118) kein NF2-Signal (40) gemessen wurde, und
- wobei der Störlichtbogen (16) erkannt bzw. gemeldet wird,
∘ wenn innerhalb des Parallelzeitraums (116) zwischen allen aufeinanderfolgenden HF2-Signalen (48) der zeitliche Abstand größer oder gleich einer ersten Störlichtbogen-Zeitspanne (120) ist,
∘ wenn Innerhalb des Parallelzeitraums (116) zwischen zwei direkt aufeinanderfolgenden HF2-Signalen (48) der zeitliche Abstand größer oder gleich einer zweiten Störlichtbogen-Zeitspanne (122) ist, und
∘ wenn entweder eine Anzahl HF2-Signale (48) gemessen wurde, die größer oder gleich einer ersten Störlichtbogen-Anzahl (126) ist, falls Innerhalb einer dritten Störlichtbogen-Zeitspanne (124) eine Anzahl von NF2-Signale (40) gemessen wurde, die zwischen einer zweiten Störlichtbogen-Anzahl (128) und einer dritten Störlichtbogen-Anzahl (130) liegt, oder wenn eine Anzahl von HF2-Signalen (48) gemessen wurde, die größer oder gleich einer vierten Störlichtbogen-Anzahl (132) Ist, falls innerhalb der dritten Störlichtbogen-Zeitspanne (124) eine Anzahl von NF2-Signale(40) gemessen wurde, die größer als die dritten Störlichtbogen-Anzahl (130) ist, wobei jeweils die dritten Störlichtbogen-Zeitspanne (130) mit dem Paralleizeitraum (116) beginnt.

4. verfahren (88) nach einem der Ansprüche 1 bis 3, bei dem ein HF2-Signal (48) einen Seriellzeitraum (90) startet, und bei dem der Störlichtbogen (16) erkannt und/oder gemeldet wird,
∘ wenn in einer ersten Messphase (92) des Serielizeitraums (90) eine Anzahl von HF2-Signalen (48) gemessen werden, deren zeitlicher Abstand zwischen Jeweils zwei aufeinanderfolgenden HF2-Signale (48) zwischen einer vierten Abbruch-Zeitspanne (96) und einer dritte Abbruch-Zeitspanne (94) beträgt, wenn die Anzahl der HF2-Signale (48) gleich einer ersten Seriellen-Anzahl (98) ist,
∘ wenn In einer zweiten Messphase (102), die eine Halteperiode (100) nach der ersten Messphase (92) beginnt, eine weitere Anzahl von HF2-Signale (48) gemessen wurde, deren zeitlicher Abstand zwischen jeweils zwei aufeinanderfolgenden HF2-Signale zwischen der vierten Abbruch-Zeitspanne (96) und der dritte Abbruch-Zeitspanne (94) beträgt, wenn die weitere Anzahl der HF2-Signale (48) gleich einer zweiten Seriellen-Anzahl (104) ist, und
∘ wenn innerhalb des Seriellzeitraums (90) eine Anzahl von NF1-Signalen (34) gemessen wurde, welche Anzahl gleich einer dritten Seriellen-Anzahl (119) ist, wobei der zeitliche Abstand zwischen zwei aufeinanderfolgenden NF1-Signalen (34) zwischen einer fünften Abbruch-Zeitspanne (106) und einer sechsten Abbruch-Zeltspanne (108) liegt, und wenn nach dem letzten der NF1-Signale (34) für zumindest eine Zeitspanne, die der fünften Abbruch-Zeitspanne (106) entspricht, kein weiteres NF1-Signal (34) gemessen wurde,
wobei der Seriellzeitraum (90) beendet wird, falls in einer der Messphasen (92, 102) der zeitliche Abstand zweier direkt aufeinanderfolgender HF2-Signale (48) größer als die dritte Abbruch-Zeitspanne (94) ist.

5. Verfahren nach Anspruch 4, bei dem der Seriellzeitraum (90) beendet wird, falls dieser bereits begonnen hat, und der Seriellzeitraum (90) für eine erste SPG-Zeitspanne nicht gestartet wird, wenn entweder für eine zweite SPG-Zeitspanne (140) die Spannung (24) nicht größer als eine SPG-Spannung (134) ist, oder sich die Längen zweier aufeinanderfolgender Hochzeitspannen (136) um mehr als eine dritte SPG-Zeitspanne unterscheiden, wobei die Hochzeitspannen (136) die Zeitspanne ist, innerhalb derer die Spannung (24) größer als die SPG-Spannung (134) ist.

6. Verfahren nach Anspruch 4 oder 5, bei dem der Seriellzeitraum (90) beendet wird, falls dieser bereits begonnen hat, und der Seriellzeitraum (90) für einen Parallelzeitraum (116) nicht gestartet wird, falls ein NF2-Signal (40) gemessen wird, das länger als eine NF2-Grenzlänge (114) andauert,
- wobei ein auftretendes Störsignal (28), das eine Frequenz unterhalb einer NF2-Frequenz (36) und eine Stromstärke des elektrischen Stroms des Stromkreises oberhalb einer NF2-Grenzschwelle (38) aufweist, als NF2-Signal (40) bezeichnet wird, und
- wobei der Parallelzeitraum (116) beendet wird, wenn
∘ ein gemessenes NF2-Signal (40) kürzer als die NF2-Grenzlänge (114) andauert, oder
∘ die Spannung (24) für eine ersten Abbruch-Zeitspanne kleiner einer Abbruch-Spannung war, oder
∘ für eine zweite Abbruch-Zeitspanne (178) kein NF2-Signal (40) gemessen wurde, und
- wobei der Störlichtbogen (16) erkannt bzw. gemeldet wird,
∘ wenn innerhalb des Parallelzeitraums (116) zwischen allen aufeinanderfolgenden HF2-Signalen (48) der zeitliche Abstand größer oder gleich einer ersten Störlichtbogen-Zeitspanne (120) ist,
∘ wenn Innerhalb des Paralleizeitraums (116) zwischen zwei direkt aufeinanderfolgenden HF2-Signalen (48) der zeitliche Abstand größer oder gleich einer zweiten Störlichtbogen-Zeitspanne (122) ist, und
∘ wenn entweder eine Anzahl von HF2-Signalen (48) gemessen wurde, die größer oder gleich einer ersten Störlichtbogen-Anzahl (126) ist, falls innerhalb einer dritten Störlichtbogen-Zeitspanne (124) eine Anzahl von NF2-Signale (40) gemessen wurde, die zwischen einer zweiten Störlichtbogen-Anzahl (128) und einer dritten Störlichtbogen-Anzahl (130) liegt, oder wenn eine Anzahl HF2-Signale (48) gemessen wurde, die größer oder gleich einer vierten Störlichtbogen-Anzahl (132) ist, falls innerhalb der dritten Störlichtbogen-Zeitspanne (124) eine Anzahl von NF2-Signale(4-0) gemessen wurde, die größer als die dritten Störlichtbogen-Anzahl (130) ist, wobei jeweils die dritten Störlichtbogen-Zeitspanne (130) mit dem Paralleizeitraum (116) beginnt.

7. Schutzschalter (14), der dazu vorgesehen und eingerichtet ist das Verfahren nach einem der Ansprüche 1 bis 6 durchzuführen.

8. Schutzschalter (14) nach Anspruch 7,
**gekennzeichnet durch**
eine Unterbrechungseinheit (17) zur Unterbrechung eines Stromkreises (2), sobald der Störlichtbogen (16) erkannt bzw. gemeldet Ist.

## Claims

1. Method (76) for the detection of arc flashes (16) within an electric circuit (2) having a mains frequency (26), an electrical current (22) and an electrical voltage (24),
- wherein an occurring interfering signal (28) that has a frequency below an NF1 frequency (30) and a current strength of the electrical current of the electric circuit above an NF1 threshold (32) defines an NF1 signal (34),
- wherein a number of occurring interfering signals (28) that have a frequency below an HF2 frequency (42) are combined to form an HF2 signal (48), should the number of occurring interfering signals (28) be greater than or equal to an HF2 number (50) and should the time lag between two successive interfering signals (28) be shorter than an HF2 time (46),
- wherein a number of time periods (52), whose respective length is an accumulation length (54) and which are temporally directly successive to one another, and within which at least one respective HF2 signal (48) is located, define an accumulation (56) if the number of time periods (52) is greater than or equal to an accumulation number (58),
- wherein a WET2 accumulation counter (78) is increased by one (1) if an accumulation (56) is identified,
- wherein, when there is a lag between two accumulations (56) which is greater than or equal to a (third) accumulation time (72), either an NF period (82) is started if the WET2 accumulation counter (78) is greater than a first WET2 threshold (80), or the WET2 accumulation counter (78) is reset to zero (0) if the WET2 accumulation counter (78) is less than or equal to the first WET2 threshold (80),
- wherein an NF1 counter (84) is increased by one (1) if an NF1 signal (34) is measured within the NF period (82),
- wherein the arc flash (16) is detected and/or reported if the NF1 counter (84) exceeds a second WET2 threshold (86) within the NF period (82), and
- wherein the WET2 accumulation counter (78) and the NF1 counter (84) are reset to zero (0) after expiry of the NF period (82).

2. Method according to claim 1, wherein the NF period (82) is broken off, if this has already begun, the WET2 accumulation counter (78) and the NF1 counter (84) are reset to zero (0) and are left at zero (0) for a first SPG time period (140), if, either for a second SPG time period (140), the voltage (24) is not greater than an SPG voltage (134), or if the lengths of two successive high time intervals (136) differ by no more than a third SPG time period, wherein the high time period (136) is the time period within which the voltage (24) is greater than the SPG voltage (134).

3. Method according to claim 1 or 2, wherein the NF period (82) is broken off, if this has already begun, the WET2 accumulation counter (78) and the NF1 counter (84) are reset to zero (0) and are left at zero (0) for a parallel time period (116), if an NF2 signal (40) is measured which lasts longer than an NF2 threshold length (114),
- wherein an occurring interfering signal (28) which has a frequency below an NF2 frequency (36) and a current strength of the electrical current of the electric circuit above an NF2 threshold (38) is referred to as an NF2 signal (40), and
- wherein the parallel time period (116) is ended if
∘ a measured NF2 signal (40) lasts for less time than the NF2 threshold length (114), or
∘ the voltage (24) for a first break-off time interval was less than a break-off voltage, or
∘ if no NF2 signal (40) was measured for a second break-off time interval (118), and
- wherein the arc flash (16) is detected or reported,
∘ if, within the parallel time period (116) between all successive HF2 signals (48), the time lag is greater than or equal to a first arc flash time interval (120),
∘ if, within the parallel time period (116) between two directly successive HF2 signals (48), the time lag is greater than or equal to a second arc flash time interval (122), and
∘ if either a number of HF2 signals (48) were measured, said number being greater than or equal to a first arc flash number (126), if, within a third arc flash time interval (124), a number of NF2 signals (40) were measured, said number being between a second arc flash number (128) and a third arc flash number (130), or if a number of HF2 signals (48) were measured, said number being greater than or equal to a fourth arc flash number (132) if, within the third arc flash time interval (124), a number of NF2 signals (40) were measured, said time being greater than the third arc flash number (130), wherein the respective third arc flash time interval (130) begins with the parallel time period (116).

4. Method (88) according to one of claims 1 to 3, wherein an HF2 signal (48) initiates a series time period (90), and wherein the arc flash (16) is detected and/or reported,
∘ if, in a first measurement phase (92) of the series time period (90), a number of HF2 signals (48) are measured, the time lag of which between two respective successive HF2 signals (48) is between a fourth break-off time interval (96) and a third break-off time interval (94), if the number of HF2 signals (48) is equal to a first series number (98),
∘ if, in a second measurement phase (102) that initiates a stopping period (100) after the first measurement phase (92), a further number of HF2 signals (48) were measured, the time lag of which between two respective successive HF2 signals is between the fourth break-off time interval (96) and the third break-off time interval (94), if the further number of HF2 signals (48) is equal to a second series number (104), and
∘ if, within the series time period (90), a number of NF1 signals (34) were measured, said number being equal to a third series number (119), wherein the time lag between two successive NF1 signals (34) is between a fifth break-off time interval (106) and a sixth break-off time interval (108), and if, after the last of the NF1 signals (34) for at least one time interval corresponding to the fifth break-off time interval (106), no further NF1 signal (34) was measured,
wherein the series time period (90) is ended if, in one of the measurement phases (92, 102), the time lag between two directly successive HF2 signals (48) is greater than the third break-off time interval (94).

5. Method according to claim 4, wherein the series time period (90) is ended, if this has already begun, and the series time period (90) for a first SPG time interval is not initiated if, either for a second SPG time interval (140), the voltage (24) is not greater than an SPG voltage (134), or if the lengths of two successive high time intervals (136) differ by no more than a third SPG time interval, wherein the high time interval (136) is the time interval within which the voltage (24) is greater than the SPG voltage (134).

6. Method according to claim 4 or 5, wherein the series time period (90) is ended, if this has already begun, and the series time period (90) for a parallel time period (116) is not initiated if an NF2 signal (40) is measured which last longer than an NF2 threshold length (114),
- wherein an occurring interfering signal (28) which has a frequency below an NF2 frequency (36) and a current strength of the electrical current of the electric circuit above an NF2 threshold (38) is referred to as an NF2 signal (40), and
- wherein the parallel time period (116) is ended if
o a measured NF2 signal (40) lasts for less time than the NF2 threshold length (114), or
o the voltage (24) for a first break-off time interval was less than a break-off voltage, or
∘ no NF2 signal (40) was measured for a second break-off time interval (118), and
- wherein the arc flash (16) is detected or reported,
o if, within the parallel time period (116) between all successive HF2 signals (48), the time lag is greater than or equal to a first arc flash time interval (120),
∘ if, within the parallel time period (116) between two directly successive HF2 signals (48), the time lag is greater than or equal to a second arc flash time interval (122), and
∘ if either a number of HF2 signals (48) were measured, said number being greater than or equal to a first arc flash number (126), if, within a third arc flash time interval (124), a number of NF2 signals (40) were measured, said number being between a second arc flash number (128) and a third arc flash number (130), or if a number of HF2 signals (48) were measured, said number being greater than or equal to a fourth arc flash number (132) if, within the third arc flash time interval (124), a number of NF2 signals (40) were measured, said number being greater than the third arc flash number (130), wherein the respective third arc flash time interval (130) begins with the parallel time period (116).

7. Circuit breaker (14) provided and equipped to carry out the method according to one of claims 1 to 6.

8. Circuit breaker (14) according to claim 7,
**characterised by**
an interruption unit (17) for interrupting an electric circuit (2) as soon as the arc flash (16) is detected or reported.

## Revendications

1. Procédé (76) de reconnaissance d'arcs parasites (16) à l'intérieur d'un circuit électrique (2) comportant une fréquence de réseau (26), un courant électrique (22) et une tension électrique (24),
- dans lequel un signal parasite se produisant (28), qui présente une fréquence inférieure à une fréquence NF1 (30) et une intensité de courant du courant électrique du circuit électrique supérieure à un seuil limite NF1 (32), définit un signal NF1 (34),
- dans lequel une pluralité de signaux parasites se produisant (28), qui présente une fréquence inférieure à une fréquence HF2 (42), sont rassemblés en un signal HF2 (48), si la pluralité de signaux parasites se produisant (28) est supérieure ou égale à une pluralité de HF2 (50) et l'écart temporel entre de signaux parasites consécutifs (28) est inférieur à un temps HF2 (46),
- dans lequel une pluralité de périodes (52), dont la longueur respective est une longueur d'accumulation (54) et qui se suivent directement temporellement ainsi que dans lesquelles se trouve respectivement au moins un signal HF2 (48), définissent une accumulation (56), lorsque la pluralité de périodes (52) est supérieure ou égale à une pluralité d'accumulations (58),
- dans lequel un compteur d'accumulation WET2 (78) est augmenté de un (1), si une accumulation (56) est identifiée,
- dans lequel, dans le cas d'un écart entre deux accumulations (56), lequel écart est supérieur ou égal à un (troisième) temps d'accumulation (72), soit une période NF (82) est commencée, si le compteur d'accumulation WET2 (78) est supérieur à une première valeur limite WET2 (80), soit le compteur d'accumulation WET2 (78) est ramené à zéro (0), si le compteur d'accumulation WET2 (78) est inférieur ou égal à la première valeur limite WET2 (80),
- dans lequel un compteur NF1 (84) est augmenté de un (1), si un signal NF1 (34) est mesuré pendant la période NF (82),
- dans lequel l'arc parasite (16) est reconnu et/ou signalé, si le compteur NF1 (84) pendant la période NF (82) dépasse une seconde valeur limite WET2 (86), et
- dans lequel le compteur d'accumulation WET2 (78) et le compteur NF1 (84) sont ramenés à zéro (0) après écoulement de la période NF (82).

2. Procédé selon la revendication 1, dans lequel la période NF (82) est interrompue, si celle-ci a déjà commencé, le compteur d'accumulation WET2 (78) et le compteur NF1 (84) sont ramenés à zéro (0) et ceux-ci sont maintenus à zéro (0) pour une première période de temps SPG, lorsque soit la tension (24) n'est pas supérieure à une tension SPG (134) pour une seconde période de temps SPG (140), soit les longueurs de deux périodes de temps élevées consécutives (136) se différencient de plus d'une troisième période de temps SPG, dans lequel les périodes de temps élevées (136) sont la période de temps, à l'intérieur de laquelle la tension (24) est supérieure à la tension SPG (134).

3. Procédé selon la revendication 1 ou 2, dans lequel la période NF1 (82) est interrompue, si celle-ci a déjà commencé, le compteur d'accumulation WET2 (78) et le compteur NF1 (84) sont ramenés à zéro (0) et sont maintenus à zéro (0) pour une période parallèle (116), si un signal NF2 (40) est mesuré, qui dure plus longtemps qu'une longueur limite NF2 (114),
- dans lequel un signal parasite se produisant (28), qui présente une fréquence inférieure à une fréquence NF2 (36) et une intensité de courant du courant électrique du circuit électrique supérieure à un seuil limite NF2 (38), est désigné comme signal NF2 (40), et
- dans lequel la période parallèle (116) est terminé, lorsque
∘ un signal NF2 mesuré (40) est plus court que la longueur limite NF2 (114), ou
∘ la tension (24) pour une première période de temps d'interruption était inférieur à une tension d'interruption, ou
∘ lorsqu'aucun signal NF2 (40) n'est mesuré pour une seconde période de temps d'interruption (118), et
- dans lequel l'arc parasite (16) est reconnu ou signalé,
∘ lorsque l'écart temporel est supérieur ou égal à une première période de temps d'arc parasite (120) à l'intérieur d'une période parallèle (116) entre tous les signaux HF2 consécutifs (48),
∘ lorsque l'écart temporel est supérieur ou égal à une seconde période de temps d'arc parasite (122) à l'intérieur de la période parallèle (116) entre deux signaux HF2 directement consécutifs (48), et
∘ lorsque soit une pluralité de signaux HF2 (48) est mesurée, qui est supérieure ou égale à une première pluralité d'arcs parasites (126), si une pluralité de signaux NF2 (40) est mesurée à l'intérieur d'une troisième période de temps d'arc parasite (124), qui se trouve entre une seconde pluralité d'arcs parasites (128) et une troisième pluralité d'arcs parasites (130), soit lorsqu'une pluralité de signaux HF2 (48) est mesurée, qui est supérieure ou égale à une quatrième pluralité d'arcs parasites (132), si une pluralité de signaux NF2 (40) est mesurée à l'intérieur d'une troisième période de temps d'arc parasite (124), qui est supérieure à la troisième pluralité d'arcs parasites (130), dans lequel la troisième période de temps d'arc parasite (130) commence respectivement avec la période parallèle (116).

4. Procédé (88) selon l'une des revendications 1 à 3, dans lequel un signal HF2 (48) démarre une période série (90), et dans lequel l'arc parasite (16) est reconnu et/ou signalé,
∘ lorsque, dans une première phase de mesure (92) de la période série (90) est mesurée une pluralité de signaux HF2 (48), dont l'écart temporel entre deux signaux HF2 consécutifs respectifs (48) est compris entre une quatrième période d'interruption (96) et une troisième période d'interruption (94), lorsque la pluralité de signaux HF2 (48) est égale à une première pluralité série (98),
∘ lorsque, dans une seconde phase de mesure (102), qui commence une période d'arrêt (100) après la première phase de mesure (92), une autre pluralité de signaux HF2 (48) est mesurée, dont l'écart temporel entre deux signaux HF2 consécutifs respectifs est compris entre la quatrième période de temps d'interruption (96) et la troisième période de temps d'interruption (94), lorsque l'autre pluralité de signaux HF2 (48) est égale à une seconde pluralité série (104), et
∘ lorsque, à l'intérieur de la période série (90), une pluralité de signaux NF1 (34) est mesurée, laquelle pluralité est égale à une troisième pluralité série (119), dans lequel l'écart temporel entre deux signaux NF1 consécutifs (34) se trouve entre une cinquième période de temps d'interruption (106) et une sixième période de temps d'interruption (108), et lorsque, après le dernier des signaux NF1 (34) pour au moins une période de temps, qui correspond à la cinquième période de temps d'interruption (106), aucun autre signal NF1 (34) n'est mesuré, dans lequel la période série (90) est terminée, si, dans une des phases de mesure (92, 102), l'écart temporel entre deux signaux HF2 (48) directement consécutifs est supérieur à la troisième période de temps d'interruption (94).

5. Procédé selon la revendication 4, dans lequel la période série (90) est terminée, si celle-ci a déjà commencé, et la période série (90) n'est pas commencée pour une première période SPG, lorsque soit, pour une seconde période SPG (140), la tension (24) n'est pas supérieure à une tension SPG (134), soit les longueurs entre deux périodes de temps élevées consécutives (136) se différencient de plus d'une troisième période SPG, dans laquelle les périodes de temps élevées (136) sont la période, à l'intérieur de laquelle la tension (24) est supérieure à la tension SPG (134).

6. Procédé selon la revendication 4 ou 5, dans lequel la période série (90) est terminée, si celle-ci a déjà commencé, et la période série (90) n'est pas commencée pour une période parallèle (116), si un signal NF2 (40) est mesuré, qui dure plus longtemps qu'une longueur limite NF2 (114),
- dans lequel un signal parasite se produisant (28), qui présente une fréquence inférieure à une fréquence NF2 (36) et une intensité de courant du courant électrique du circuit électrique supérieure à un seuil limite NF2 (38) est désigné comme signal NF2 (40), et
- dans lequel la période parallèle (116) est terminée, lorsque
∘ un signal NF2 mesuré (40) est plus court que la longueur limite NF2 (114), ou
∘ la tension (24) pour une première période de temps d'interruption était inférieure à une tension d'interruption, ou
∘ aucun signal NF2 (40) n'est mesuré pour une seconde période de temps d'interruption (118), et
- dans lequel l'arc parasite (16) est reconnu ou signalé,
∘ lorsque, à l'intérieur de la période parallèle (116) entre tous les signaux HF2 consécutifs (48), l'écart temporel est supérieur ou égal à une première période de temps d'arc parasite (120),
∘ lorsque, à l'intérieur de la période parallèle (116) entre deux signaux HF2 directement consécutifs (48), l'écart temporel est supérieur ou égal à une seconde période de temps d'arc parasite (122), et
∘ lorsque, soit une pluralité de signaux HF2 (48) est mesurée, qui est supérieure ou égale à une première pluralité d'arcs parasites (126), si, à l'intérieur d'une troisième période de temps d'arc parasite (124), une pluralité de signaux NF2 (40) est mesurée, qui se trouve entre une seconde pluralité d'arcs parasites (128) et une troisième pluralité d'arcs parasites (130), soit lorsqu'une pluralité de signaux HF2 (48) est mesurée, qui est supérieure ou égale à une quatrième pluralité d'arcs parasites (132), si, à l'intérieur de la troisième période de temps d'arc parasite (124), une pluralité de signaux NF2 (40) est mesurée, qui est supérieure à la troisième pluralité d'arcs parasites (130), dans lequel la troisième période temporelle d'arc parasite (130) respective commence avec la période parallèle (116).

7. Disjoncteur (14), qui est prévu et réalisé pour exécuter le procédé selon l'une des revendications 1 à 6.

8. Disjoncteur (14) selon la revendication 7, **caractérisé par**
une unité d'interruption (17) pour interrompre un circuit électrique (2), dès que l'arc parasite (16) est reconnu ou signalé.
